(19)

Europäisches
Patentamt
European
Patent Office
Office européen
des brevets

(11) **EP 2 746 789 A1**

(12) **EUROPEAN PATENT APPLICATION**
published in accordance with Art. 153(4) EPC

(43) Date of publication:
**25.06.2014 Bulletin 2014/26**

(51) Int Cl.:
*G01R 31/02* (2006.01)        *H01L 31/04* (2014.01)
*H01L 31/042* (2014.01)

(21) Application number: **12820476.5**

(22) Date of filing: **31.07.2012**

(86) International application number:
**PCT/JP2012/069446**

(87) International publication number:
**WO 2013/018794 (07.02.2013 Gazette 2013/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.08.2011   JP 2011168703**

(71) Applicant: **JX Nippon Oil & Energy Corporation
Chiyoda-ku
Tokyo 100-8162 (JP)**

(72) Inventors:
• **YOSHIDOMI Masanobu
  Nagoya-shi
  Aichi 465-0092 (JP)**
• **ISHII Takafumi
  Tokyo 100-8162 (JP)**

(74) Representative: **Grünecker, Kinkeldey,
Stockmair & Schwanhäusser
Leopoldstrasse 4
80802 München (DE)**

(54) **EARTH FAULT DETECTION DEVICE, EARTH FAULT DETECTION METHOD, SOLAR POWER GENERATION SYSTEM, AND EARTH FAULT DETECTION PROGRAM**

(57)   In a ground fault detection device 1, two photovoltaic strings $103_1$ and $103_n$ are disconnected from a photovoltaic power generation system 100, a measurement of a first voltage value is performed for the one photovoltaic string $103_1$ by a first measurement unit 3A, and in parallel therewith, a measurement of a second voltage value is performed for the other photovoltaic string $103_n$ by the second measurement unit 3B by executing various functions of a calculation control unit 4. Thus, a capacitance relative to a ground of a measurement target is reduced. Further, the photovoltaic string is electrically separated from a load device at the time of such a measurement. Further, separate measurements are performed on the one and other photovoltaic strings $103_1$ and $103_n$ in the disconnected state, and the first and second voltage values are measured in parallel.

**Fig.1**

## Description

### Technical Field

The present invention relates to a ground fault detection device, a ground fault detection method, a photovoltaic power generation system, and a ground fault detection program.

### Background Art

In a photovoltaic power generation system which performs power generation using solar light, generally, a plurality of photovoltaic modules are connected in series to constitute a photovoltaic string, and a plurality of photovoltaic strings are connected in parallel to constitute a photovoltaic array. An output from this photovoltaic array is supplied to a load device such as a power conditioner and is supplied to a commercial power system or the like.

In such a photovoltaic power generation system, when there is an insulation failure in the photovoltaic array, for example, when a person or an object touches an insulation failure point or when the insulation failure point and a metal stand or the like come in contact with each other, a ground fault at which an electrical circuit comes in contact with the outside in an unintentional form may occur. Conventionally, for example, a ground fault detection device described in Patent Literature 1 is known as a device which detects this ground fault. In the ground fault detection device disclosed in Patent Literature 1, a value of the current flowing from an electrical path of a grounded photovoltaic array to the ground is measured, and the ground fault of the photovoltaic array is detected when this current value exceeds a current setting value, which has been set in advance.

### Citation List

### Patent Literature

[Patent Literature 1] Japanese Patent Laid-Open Publication No. 2003-158282

### Summary of Invention

### Technical Problem

However, in the above ground fault detection device, there is concern of the ground fault being erroneously detected due to an influence of a capacitance relative to a ground of a photovoltaic power generation system. Further, it is easily affected by noise generated due to a load device (e.g., noise generated due to a high frequency switch operation or due to a commercial frequency (50 to 60 Hz) or the like) at the time of ground fault detection and therefore there is concern of the ground fault being erroneously detected.

Further, in a recent ground fault detection device, reduction of a time required for detection of a ground fault within a photovoltaic array is greatly required, for example, with the spread and expansion of photovoltaic power generation systems.

Therefore, an object of the present invention is to provide a ground fault detection device, a ground fault detection method, a photovoltaic power generation system, and a ground fault detection program capable of reliably detecting a ground fault and shortening a time required for detection of the ground fault.

### Solution to Problem

In order to achieve the above object, a ground fault detection device according to an aspect of the present invention is a ground fault detection device which detects a ground fault within a photovoltaic array in a photovoltaic power generation system including photovoltaic strings configured in such a manner that a plurality of photovoltaic modules are connected in series; the photovoltaic array configured in such a manner that the plurality of photovoltaic strings are connected in parallel; and a load device which consumes or converts power, wherein the ground fault detection device includes a switching unit which disconnects two or more photovoltaic strings among the plurality of photovoltaic strings from the photovoltaic power generation system electrically separating the photovoltaic strings from each other; a first measurement unit which measures a first measurement value for ground fault detection for each of the plurality of photovoltaic strings; a second measurement unit which performs a measurement separate from the measurement of the first measurement unit for each of the plurality of photovoltaic strings to measure a second measurement value for ground fault detection; a determination unit which determines whether there is a ground fault based on the first and second measurement values measured by the first and second measurement units for each of the plurality of photovoltaic strings; and a control unit which at least controls operations of the first and second measurement units, and the control unit connects the first measurement unit to one photovoltaic string among the two or more photovoltaic strings disconnected by the switching unit and causes the first measurement unit to measure the first measurement value of the one photovoltaic string, and in parallel therewith, connects the second measurement unit to the other photovoltaic string among the two or more photovoltaic strings disconnected by the switching unit and causes the second measurement unit to measure the second measurement value of the other photovoltaic string.

In the ground fault detection device of the one aspect, the one and other photovoltaic strings for which the first and second measurement values for ground fault detection are to be measured are disconnected from the photovoltaic power generation system. Therefore, the capacitance relative to a ground of a measurement target can be reduced, adverse effects resulting from the capacitance relative to a ground on ground fault detection can be reduced, and adverse effects of noise caused by the load device on ground fault detection can be reduced since the photovoltaic string is electrically separated from the load device at the time of measurement. Therefore, it is possible to reliably detect the ground fault.

Further, separate measurements are performed in parallel on the one and other photovoltaic strings in the disconnected state, and therefore the first and second measurement values are measured in parallel. Thus, it is possible to achieve efficiency of the measurement of the first and second measurement values and to achieve efficiency of ground fault detection. Therefore, it is possible to shorten a time required for detection of the ground fault within the photovoltaic array.

Incidentally, "one photovoltaic string" herein refers to any at least one photovoltaic string, and "other photovoltaic string" refers to another (remaining) at least one photovoltaic string. Further, "parallel" herein may refer to, for example, parallel, substantially parallel, simultaneously parallel, simultaneously in parallel, simultaneously, substantially simultaneously, or simultaneous. Specifically, "parallel" refers to there being at least an overlapping time between a period in which measurement is performed and a period in which charging/discharging is performed. These apply likewise hereinafter.

Further, a ground fault detection method according to a first other aspect of the present invention is a ground fault detection method for detecting a ground fault within a photovoltaic array in a photovoltaic power generation system comprising photovoltaic strings configured in such a manner that a plurality of photovoltaic modules are connected in series; the photovoltaic array configured in such a manner that the plurality of photovoltaic strings are connected in parallel; and a load device which consumes or converts power, wherein the ground fault detection method includes a disconnection step of disconnecting two or more photovoltaic strings among the plurality of photovoltaic strings from the photovoltaic power generation system electrically separating the photovoltaic strings from each other; a first measurement step of measuring a first measurement value for ground fault detection for each of the plurality of photovoltaic strings; a second measurement step of performing a measurement separate from the measurement of the first measurement step for each of the plurality of photovoltaic strings to measure a second measurement value for ground fault detection; and a determination step of determining whether there is a ground fault based on the first and second measurement values measured in the first and second measurement steps for each of the plurality of photovoltaic strings, the first measurement step includes measuring the first measurement value in one photovoltaic string among the two or more photovoltaic strings disconnected in the disconnection step, and the second measurement step includes measuring the second measurement value in the other photovoltaic string among the two or more photovoltaic strings disconnected in the disconnection step, in parallel with measuring the first measurement value in the first measurement step.

Further, a photovoltaic power generation system according to a second other aspect of the present invention includes: photovoltaic strings configured in such a manner that a plurality of photovoltaic modules are connected in series; a photovoltaic array configured in such a manner that the plurality of photovoltaic strings are connected in parallel; a load device which consumes or converts power; and the ground fault detection device.

Further, a ground fault detection program according to a third other aspect of the present invention is a ground fault detection program for detecting a ground fault within a photovoltaic array in a photovoltaic power generation system including photovoltaic strings configured in such a manner that a plurality of photovoltaic modules are connected in series; the photovoltaic array configured in such a manner that the plurality of photovoltaic strings are connected in parallel; and a load device which consumes or converts power, wherein the ground fault detection program causes a computer to execute: a disconnection function for disconnecting two or more photovoltaic strings among the plurality of photovoltaic strings from the photovoltaic power generation system electrically separating the photovoltaic strings from each other; a first measurement function for measuring a first measurement value for ground fault detection for each of the plurality of photovoltaic strings; a second measurement function for performing a measurement separate from the measurement by the first measurement function for each of the plurality of photovoltaic strings to measure a second measurement value for ground fault detection; and a determination function for determining whether there is a ground fault based on the first and second measurement values measured through the first and second measurement functions for each of the plurality of photovoltaic strings, the first measurement function includes measuring the first measurement value in one photovoltaic string among the two or more photovoltaic strings disconnected through the disconnection function, and the second measurement function includes measuring the second measurement value in the other photovoltaic string among the two or more photovoltaic strings disconnected in the disconnection function, in parallel with measuring the first measurement value through the first measurement function.

In the ground fault detection method, the photovoltaic power generation system and the ground fault detection program according to these other aspects, the one and other photovoltaic strings for which the first and second measurement values for ground fault detection are to be measured can be disconnected from the photovoltaic power generation system. Further, separate measurements can be performed in parallel on the one and other photovoltaic strings in the disconnected state, thereby achieving efficiency of ground fault detection. Thus, the action effects described above, i.e., action effects of reliably detecting the ground fault and shortening a time required for detection of the ground fault, are achieved.

**Advantageous Effects of Invention**

According to the present invention, it is possible to reliably detect the ground fault and to shorten a time required for detection of the ground fault.

**Brief Description of Drawings**

Fig. 1 is a schematic configuration diagram illustrating a state of a photovoltaic power generation system including a ground fault detection device according to a first embodiment.
Fig. 2 is a schematic configuration diagram illustrating another state in the photovoltaic power generation system of Fig. 1.
Fig. 3 is a diagram illustrating an example of a first potential state of this embodiment.
Fig. 4 is a diagram illustrating an example of a second potential state of this embodiment.
Fig. 5 is a functional block diagram illustrating a calculation control unit of the ground fault detection device of Fig. 1.
Fig. 6 is a flowchart illustrating operation of the ground fault detection device of Fig. 1.
Fig. 7 is another flowchart illustrating operation of the ground fault detection device of Fig. 1.
Fig. 8 is a diagram illustrating an operation scheme of each photovoltaic string in the ground fault detection device of Fig. 1.
Fig. 9 is a schematic configuration diagram illustrating a state of a photovoltaic power generation system including a ground fault detection device according to a second embodiment.
Fig. 10 is a schematic configuration diagram illustrating another state in the photovoltaic power generation system of Fig. 9.
Fig. 11 is a flowchart illustrating operation of the ground fault detection device of Fig. 9.
Fig. 12 is a diagram illustrating an operation scheme of each photovoltaic string in the ground fault detection device of Fig. 9.
Fig. 13 is a schematic configuration diagram illustrating a state of a photovoltaic power generation system including a ground fault detection device according to a third embodiment.
Fig. 14 is a schematic configuration diagram illustrating another state in the photovoltaic power generation system of Fig. 13.
Fig. 15 is a flowchart illustrating operation of the ground fault detection device of Fig. 13.
Fig. 16(a) is a diagram illustrating an example of a potential state in this embodiment, and Fig. 16(b) is a diagram illustrating another example of the potential state in this embodiment.
Fig. 17 is a diagram illustrating an operation scheme of each photovoltaic string in the ground fault detection device of Fig. 13.
Fig. 18 is a schematic configuration diagram illustrating a state of a photovoltaic power generation system including a ground fault detection device according to a fourth embodiment.
Fig. 19 is a schematic configuration diagram illustrating another state in the photovoltaic power generation system of Fig. 18.
Fig. 20 is a schematic configuration diagram illustrating another separate state in the photovoltaic power generation system of Fig. 18.
Fig. 21 is a schematic configuration diagram illustrating yet another separate state in the photovoltaic power generation system of Fig. 18.
Fig. 22 is a flowchart illustrating operation of the ground fault detection device of Fig. 18.
Fig. 23 is a diagram illustrating an operation scheme of each photovoltaic string in the ground fault detection device of Fig. 18.

Fig. 24 is a schematic configuration diagram illustrating a state of a photovoltaic power generation system including a ground fault detection device according to a fifth embodiment.

Fig. 25 is a schematic configuration diagram illustrating another state in the photovoltaic power generation system of Fig. 24.

Fig. 26(a) is a diagram illustrating an example of a potential state in this embodiment, and Fig. 26(b) is a diagram illustrating another example of the potential state in this embodiment.

Fig. 27 is a flowchart illustrating operation of the ground fault detection device of Fig. 24.

Fig. 28 is a diagram illustrating an operation scheme of each photovoltaic string in the ground fault detection device of Fig. 24.

Fig. 29 is a diagram illustrating another example of the potential state.

Fig. 30 is a diagram illustrating yet another example of the potential state.

## Description of Embodiments

[First embodiment]

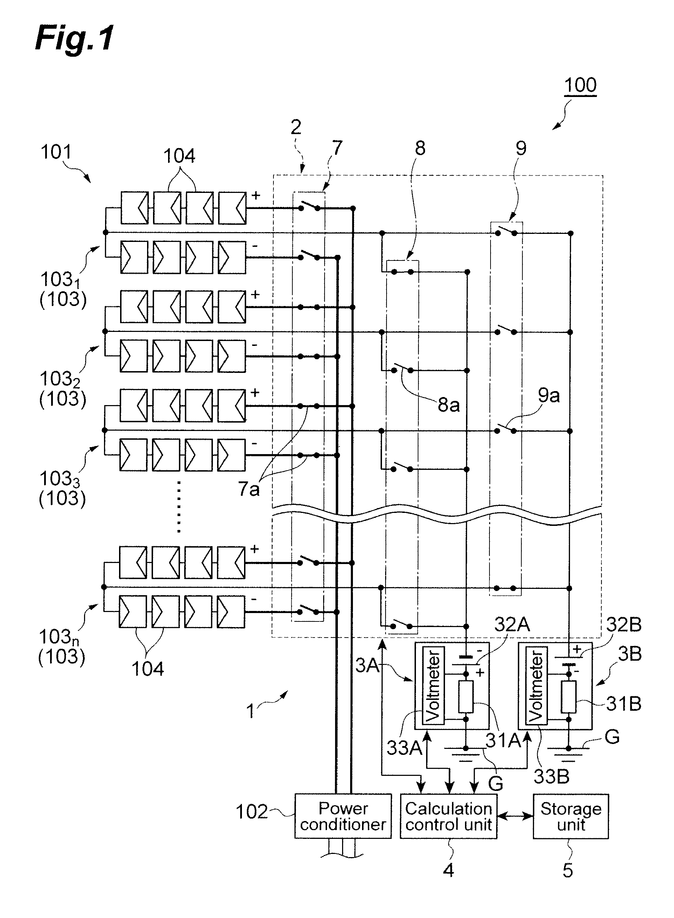

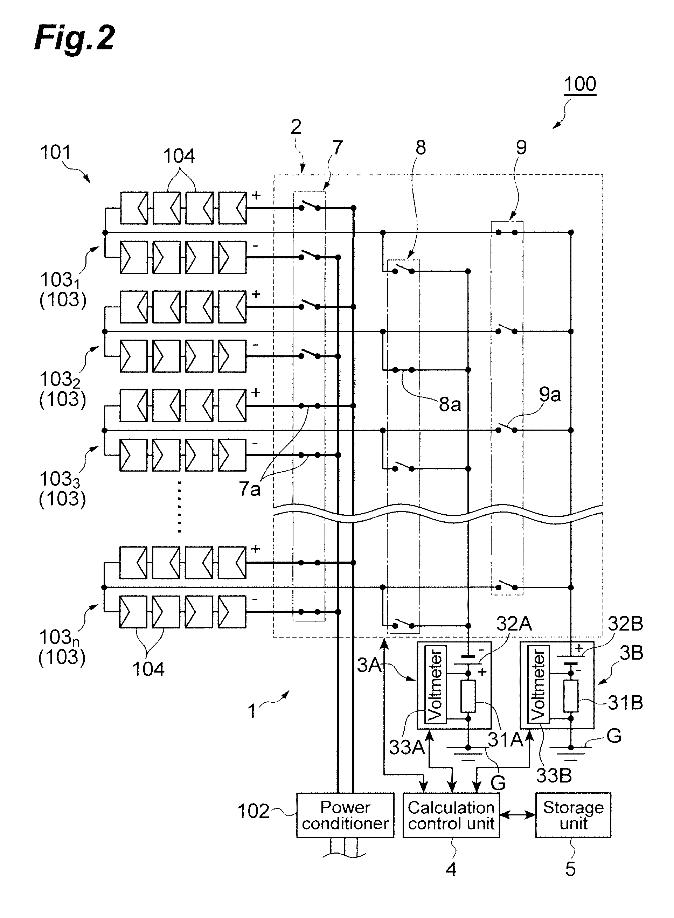

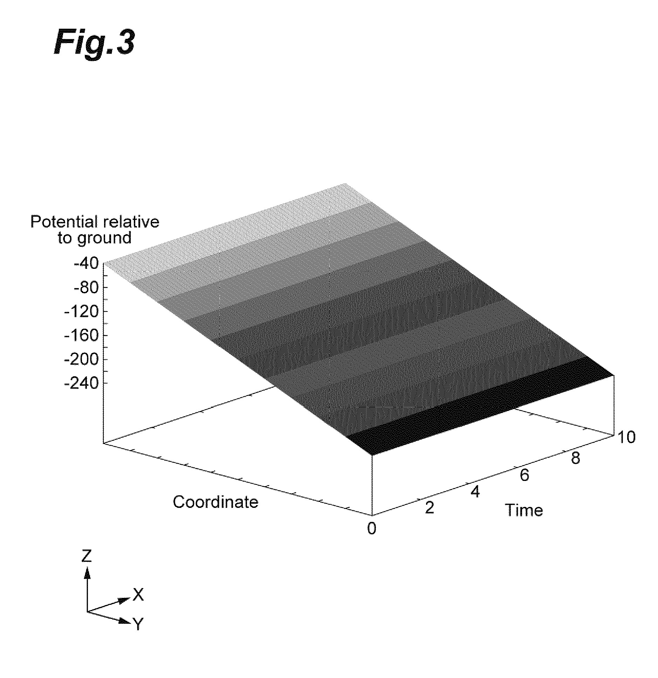

A first embodiment of the present invention will be described. Figs. 1 and 2 are schematic configuration diagrams illustrating a photovoltaic power generation system including a ground fault detection device according to the first embodiment. Fig. 3 is a functional block diagram illustrating a calculation control unit of the ground fault detection device illustrated in Fig. 1. The ground fault detection device 1 detects a ground fault within a photovoltaic array 101 in the photovoltaic power generation system 100, as illustrated in Figs. 1 and 2. Therefore, this photovoltaic power generation system 100 will first be described.

The photovoltaic power generation system 100 is a power generation system which performs power generation using solar energy, and includes the photovoltaic array 101, and a power conditioner (a load device) 102. The photovoltaic array 101 converts solar energy into electrical energy and supplies the electrical energy to the power conditioner 102 as direct current output. The photovoltaic array 101 has a configuration in which a plurality of photovoltaic strings 103 are connected in parallel. In other words, in the photovoltaic array 101, first to $n^{th}$ photovoltaic strings $103_1$ to $103_n$ are connected in parallel (n is an integer equal to or more than 2).

Each of the plurality of photovoltaic strings 103 has a configuration in which a plurality of (here, 8) photovoltaic modules 104 are connected in series. The plurality of photovoltaic strings 103 are connected to the power conditioner 102 through a disconnection switch 7, which will be described below.

The power conditioner 102 converts the direct current output supplied from the photovoltaic array 101 into an alternating current output and supplies this alternating current output to a power system (e.g., a commercial power system) of a subsequent stage. This power conditioner 102 has an operation voltage control function for controlling an operation voltage of the photovoltaic array 101 so that a maximum output is obtained, and a system protection function such of safely stopping the system when abnormality of the power system is detected. Further, the power conditioner 102 may be a transformer insulation type having an isolation transformer or may be a transformerless (non-insulation) type.

The ground fault detection device 1 of this embodiment includes a switching unit 2, first and second measurement units 3A and 3B, a calculation control unit 4 and a storage unit 5. The switching unit 2 is a unit which performs opening/closing of the electrical circuit, and specifically, disconnects two or more (here, two) photovoltaic strings 103 from the photovoltaic power generation system 100 at the same time, connects the one photovoltaic string 103 in the disconnected state to the first measurement unit 3A, and in parallel therewith, connects the other photovoltaic string 103 in the disconnected state to the second measurement unit 3B. Further, "one" herein means any at least one and "the other" means at least one of other units (remaining units).

This switching unit 2 includes a disconnection switch (switching unit) 7 for disconnecting each photovoltaic string 103 from the photovoltaic power generation system 100, a first measurement switch 8 for connecting the disconnected photovoltaic string 103 to the first measurement unit 3A, and a second measurement switch 9 for connecting the disconnected photovoltaic string 103 to the second measurement unit 3B. Within this switching unit 2, positive electrodes and negative electrodes of the respective photovoltaic strings 103 are collected and connected in parallel to form a positive electrode bus and a negative electrode bus.

The disconnection switch 7 is located between the photovoltaic string 103 and the power conditioner 102 and switches electrical connection/non-connection therebetween. The disconnection switch 7 includes a plurality of disconnection switch elements 7a connected in series with the positive electrodes and the negative electrodes of the respective photovoltaic strings 103. The disconnection switch element 7a is connected to the calculation control unit 4, and switches ON/OFF according to an instruction signal from the calculation control unit 4. The disconnection switch element 7a herein is usually turned on to enter an electrically connected state, but is turned off to enter an electrically blocked state at the time of ground fault detection.

Further, terminals on the power conditioner 102 side of the plurality of disconnection switch elements 7a are connected in such a manner that the positive electrodes are connected to one another and the negative electrodes are connected to one another to thereby form a positive electrode bus and a negative electrode bus. The positive electrode bus and the negative electrode bus are connected to the power conditioner 102. A semiconductor switch such as an FET (Field Effect Transistor) or a mechanical switch such as a relay switch may be used as the disconnection switch element 7a.

In the disconnection switch 7 configured in this way, the two sets of disconnection switch elements 7a and 7a connected to the positive electrodes and the negative electrodes of the two photovoltaic strings 103 are sequentially turned off. Accordingly, a disconnected state in which the two photovoltaic strings 103 are electrically separated and disconnected from the photovoltaic power generation system 100 is sequentially achieved for the plurality of photovoltaic strings 103.

The first measurement switch 8 is located between the photovoltaic strings 103 and the first measurement unit 3A and switches electrical connection/non-connection therebetween. This first measurement switch 8 includes a measurement switch element 8a connected to a middle point of each of the photovoltaic strings 103. The measurement switch element 8a is connected to the calculation control unit 4, and performs ON/OFF switching according to an instruction signal from the calculation control unit 4. The measurement switch element 8a herein is usually turned off to enter an electrically blocked state, but is turned on to enter an electrically connected state at the time of a predetermined measurement.

Further, terminals on the first measurement unit 3A side of the plurality of measurement switch elements 8a are connected to thereby form a bus, and this bus is connected to the first measurement unit 3A. A semiconductor switch such as an FET or a mechanical switch such as a relay switch may be used as the measurement switch element 8a.

In the measurement switch 8 configured in this way, when two or more photovoltaic strings 103 are disconnected from the photovoltaic power generation system 100 by the disconnection switches 7, the measurement switch element 8a connected to the one of the photovoltaic strings 103 is turned on. Accordingly, the photovoltaic strings 103 are measurable by the first measurement unit 3A.

The second measurement switch 9 is located between the photovoltaic string 103 and the second measurement unit 3B, and switches electrical connection/non-connection therebetween. The second measurement switch 9 includes measurement switch elements 9a connected to the middle point of each of the photovoltaic strings 103. The measurement switch element 8a is connected to the calculation control unit 4, and performs ON/OFF switching according to an instruction signal from the calculation control unit 4. The measurement switch element 9a herein is usually turned off to enter an electrically blocked state, but is turned on to enter an electrically connected state at the time of ground fault detection.

Further, terminals on the second measurement unit 3B side in the plurality of measurement switch elements 9a are connected to form a bus, and this negative electrode bus is connected to the second measurement unit 3B. A semiconductor switch such as an FET or a mechanical switch such as a relay switch may be used as the measurement switch element 9a.

In the measurement switch 9 configured in this way, when two or more photovoltaic strings 103 are disconnected from the photovoltaic power generation system 100 by the disconnection switch 7, the measurement switch element 9a connected to the other of the photovoltaic strings 103 is turned on. Accordingly, the photovoltaic string 103 is measurable by the second measurement unit 3B.

The first and second measurement units 3A and 3B perform measurement for ground fault detection on the disconnected photovoltaic string 103. The first measurement unit 3A includes a first resistor 31 A having one side connected to the ground potential (earth) G, a first direct current power supply 32A connected to the other side of the first resistor 31A, and a first voltmeter 33A which measures a first voltage value $V_1$ generated in the first resistor 31A. The first measurement unit 3A applies a direct current voltage (a DC voltage) to the one photovoltaic string 103 disconnected by the switching unit 2 by connecting to the one photovoltaic string 103, and measures the first voltage value $V_1$ as a first measurement value in this state.

The first resistor 31A is provided between the switching unit 2 and the ground potential G on a first electrical path. A resistance value of the first resistor 31A is equal to or greater than a predetermined lower limit value from the viewpoint of safety at the time of the ground fault occurrence and is equal to or smaller than a predetermined upper limit value from the viewpoint of ease of measuring measurement values which will be described below (the same applies to the following resistors). The first direct current power supply 32A is provided between the switching unit 2 and the first resistor 31 A on the first electrical path. The first direct current power supply 32A applies a direct current voltage of a negative voltage to the middle point of the photovoltaic string 103. Here, the first direct current power supply 32A applies a direct current voltage having a first direct current voltage value $Vd_1$. Accordingly, the photovoltaic string 103 enters a first potential state. Further, with such a configuration, the first electrical path has one side connected to the ground potential G, and the other side connectable to the photovoltaic string 103.

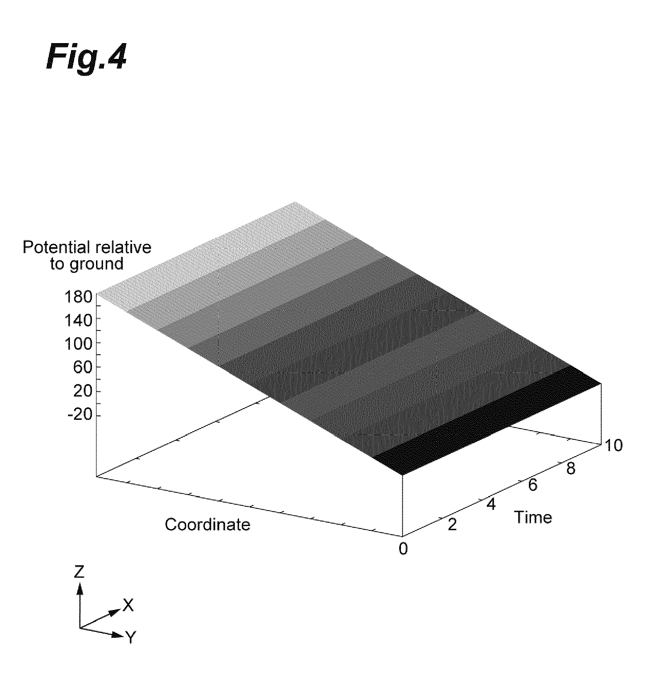

Fig. 3 is a diagram illustrating an example of a first potential state of this embodiment. In Fig. 3, a Z axis indicates a potential relative to a ground, an X axis indicates a time, and a Y axis indicates a coordinate in the photovoltaic string. Further, in Fig. 3, the potential in the photovoltaic string 103 is illustrated as linearly increasing from the negative electrode side to the positive electrode side for simplification of description. The same applies to Figs. 4, 16, 26, 29 and 30.

As illustrated in Fig. 3, the potential state means that "the potential relative to the ground of each point in the photovoltaic string 103 is expressed in a certain form as a function of a coordinate (an index indicating an electrical path position between the negative electrode and the positive electrode) in the photovoltaic string 103 and the time" (the same applies to the following potential states). The first potential state of this embodiment is a state in which the potential relative to the ground of each coordinate of the photovoltaic string 103 varies over time due to application of the first direct current voltage value $Vd_1$ and is then temporarily stabilized (converges).

Specifically, as illustrated, the first potential state is a state in which, when the voltage relative to the ground of -140 V is applied to a middle point of the photovoltaic string 103 of a voltage of 200 V as a first direct current voltage value $Vd_1$, the potential relative to the ground of the negative electrode of the photovoltaic string 103 becomes -240 V, the potential relative to the ground of the middle point of the photovoltaic string 103 becomes -140 V, the potential relative to the ground of the positive electrode of the photovoltaic string 103 becomes -40 V, and these potential states are stabilized (hardly vary over time).

Further, the first direct current voltage value $Vd_1$ is equal to or more than a predetermined lower limit value from the viewpoint of improving sensitivity of the ground fault detection, and is equal to or less than a predetermined upper limit value from the viewpoint of preventing damage of a photovoltaic circuit which is a measurement target (the same applies to the following direct current voltage values).

The first direct current power supply 32A is connected to the calculation control unit 4, and applies a direct current voltage having the first direct current voltage value $Vd_1$ according to an instruction signal from the calculation control unit 4, as illustrated in Figs. 1 and 2. Further, the calculation control unit 4 stores the first direct current voltage value $Vd_1$ applied by the first direct current power supply 32A in the storage unit 5.

The first voltmeter 33A is connected between the first resistor 31A and the first direct current power supply 32A and between the first resistor 31A and the ground potential G The first voltmeter 33A is connected to the calculation control unit 4, executes a measurement of the first voltage value $V_1$ according to an instruction signal from the calculation control unit 4, and outputs a result of the measurement to the calculation control unit 4. The calculation control unit 4 stores the measurement result in the storage unit 5.

The second measurement unit 3A includes a second resistor 31B having one side connected to the ground potential G, a second direct current power supply 32B connected to the other side of the second resistor 31B, and a second voltmeter 33A which measures a second voltage value $V_2$ generated in the second resistor 31B. The second measurement unit 3B connects to the other photovoltaic strings 103 disconnected by the switching unit 2, applies a direct current voltage (a DC voltage) to the other photovoltaic strings 103, and measures the second voltage value $V_2$ as a second measurement value in this state.

The second resistor 31B is provided between the switching unit 2 and the ground potential G on the second electrical path. A resistance value of the second resistor 31B is the same as the resistance value of the first resistor 31A. The second direct current power supply 32B is provided between the switching unit 2 and the second resistor 31 B on the second electrical path. The second direct current power supply 32B applies a direct current voltage of a positive voltage to the middle point of the photovoltaic string 103. Here, the second direct current power supply 32B applies a direct current voltage having a second direct current voltage value $Vd_2$ different from the first direct current voltage value $Vd_1$. Accordingly, the photovoltaic string 103 enters a second different potential state. Further, with such a configuration, one side of the second electrical path is connected to the ground potential G, and the other side thereof becomes connectable to the photovoltaic string 103.

Fig. 4 is a diagram illustrating an example of a second potential state of this embodiment. The second potential state of this embodiment is a potential state different from the first potential state, as illustrated in Fig. 4. The second potential state herein is a state in which the potential relative to the ground of each coordinate of the photovoltaic string 103 varies over time due to application of the second direct current voltage value $Vd_2$ and is then temporally stabilized.

Specifically, as illustrated, the second potential state of this embodiment is a state in which, when the voltage relative to the ground of +80 V is applied to the middle point of the photovoltaic string 103 of a voltage of 200 V as the second direct current voltage value $Vd_2$, the potential relative to the ground of the negative electrode of the photovoltaic string 103 becomes -20 V, the potential relative to the ground of the middle point of the photovoltaic string 103 becomes +80 V, the potential relative to the ground of the positive electrode of the photovoltaic string 103 becomes +180 V, and these potential states are stabilized.

The second direct current power supply 32B is connected to the calculation control unit 4, and applies a direct current voltage having the second direct current voltage value $Vd_2$ according to an instruction signal from the calculation control unit 4, as illustrated in Figs. 1 and 2. Further, the second direct current power supply 32B stores the second applied direct current voltage value $Vd_2$ in the storage unit 5.

The second voltmeter 33B is connected between the second resistor 31B and the second direct current power supply 32B and between the second resistor 31B and the ground potential G The second voltmeter 33B is connected to the calculation control unit 4, executes a measurement of the second voltage value $V_2$ according to an instruction signal from the calculation control unit 4, and stores a result of the measurement in the storage unit 5.

The calculation control unit 4 is a unit (computer) for controlling the entire ground fault detection device 1. The calculation control unit 4 herein executes a ground fault detection program, which will be described below, to perform measurement of the first and second measurement units 3A and 3B, storage and calculation based on the measurement result, and a determination of whether there is a ground fault. This calculation control unit 4 is connected to the switching unit 2, the first and second measurement units 3A and 3B, and the storage unit 5. The calculation control unit 4 may include a CPU (Central Processing Unit) or may include an analog IC circuit or a PLD (Programmable Logic Device) circuit.

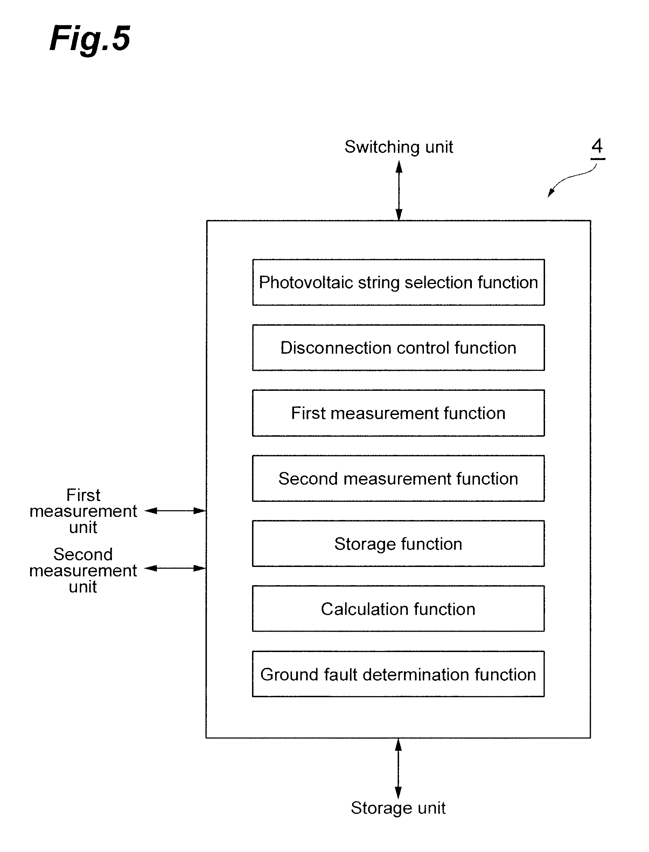

This calculation control unit 4 has a string selection function, a disconnection control function (a disconnection function), a first measurement function, a second measurement function, a storage function, a calculation function, and a ground fault determination function, as illustrated in Fig. 5. The string selection function includes selecting the photovoltaic string 103 to be disconnected from the photovoltaic power generation system 100. The disconnection control function includes instructing the disconnection switch 7 of the switching unit 2 to perform ON/OFF switching to control disconnection of the photovoltaic string 103.

The first measurement function includes instructing the first measurement switch 8 of the switching unit 2 to perform ON/OFF switching, controlling the first direct current power supply 32A to apply the direct current voltage having the first direct current voltage value $Vd_1$ to the photovoltaic array 101, and instructing the first voltmeter 33A to perform a measurement. The second measurement function includes instructing the second measurement switch 9 of the switching unit 2 to perform ON/OFF switching, controlling the second direct current power supply 32B to apply a direct current voltage having the second direct current voltage value $Vd_2$ to the photovoltaic array 101, and instructing the second voltmeter 33B to perform a measurement.

The storage function includes storing a measurement situation of each photovoltaic string 103, measurement results of the voltmeters 33A and 33B, and calculation results in the storage unit 5. The calculation function includes performing calculation based on the measurement result stored in the storage unit 5. The ground fault determination function includes determining whether there is a ground fault based on the calculation result in the calculation function.

The storage unit 5 is a recording medium for storing the ground fault detection program to be executed by the calculation control unit 4, the measurement situation of the photovoltaic array 101, the measurement results of the first and second measurement units 3A and 3B, and the calculation result of the calculation control unit 4. Further, a semiconductor memory, a magnetic storage device or the like may be used as the storage unit 5. Further, when all or a part of the ground fault detection program is not stored in the storage unit 5, all or a part of the ground fault detection program may be stored in an external storage device (e.g., a hard disk) and read to cause the calculation control unit 4 to execute a process according to ground fault detection.

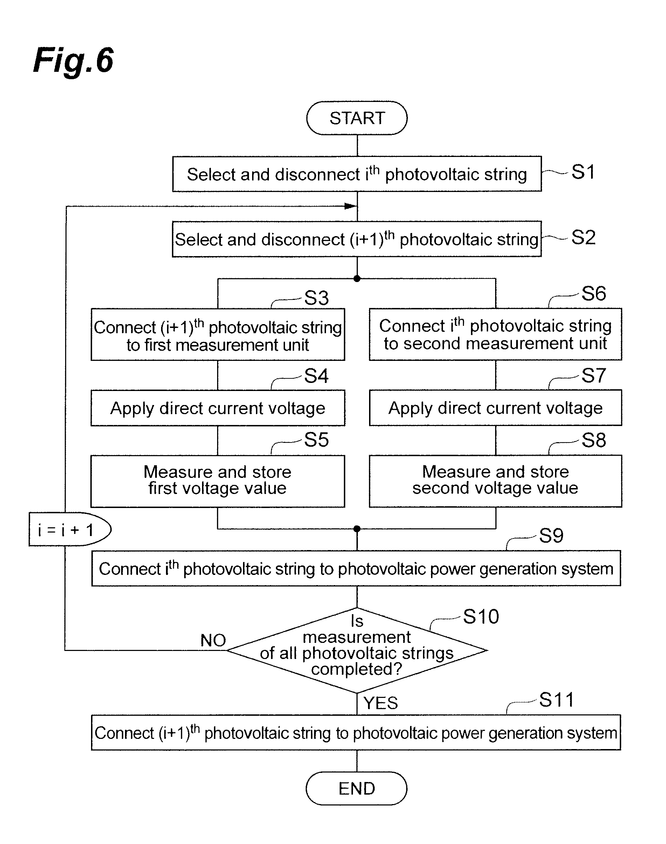

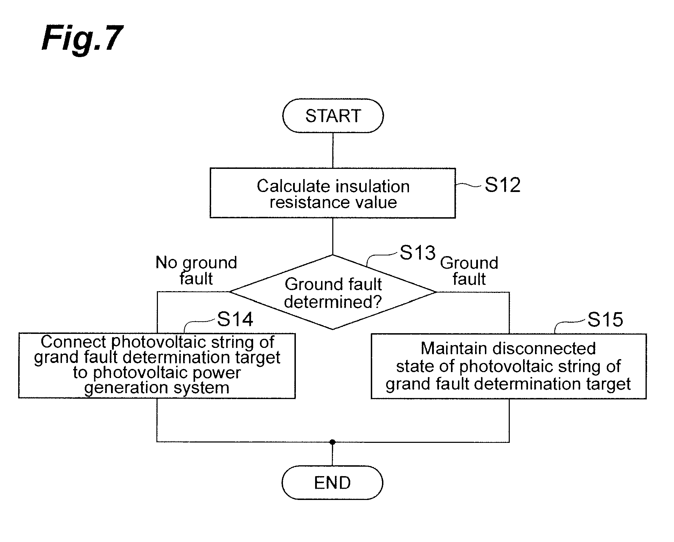

Next, an example of the ground fault detection method (operation of the ground fault detection program) performed by the ground fault detection device 1 will be illustrated and described with reference to a flowchart illustrated in Figs. 6 and 7.

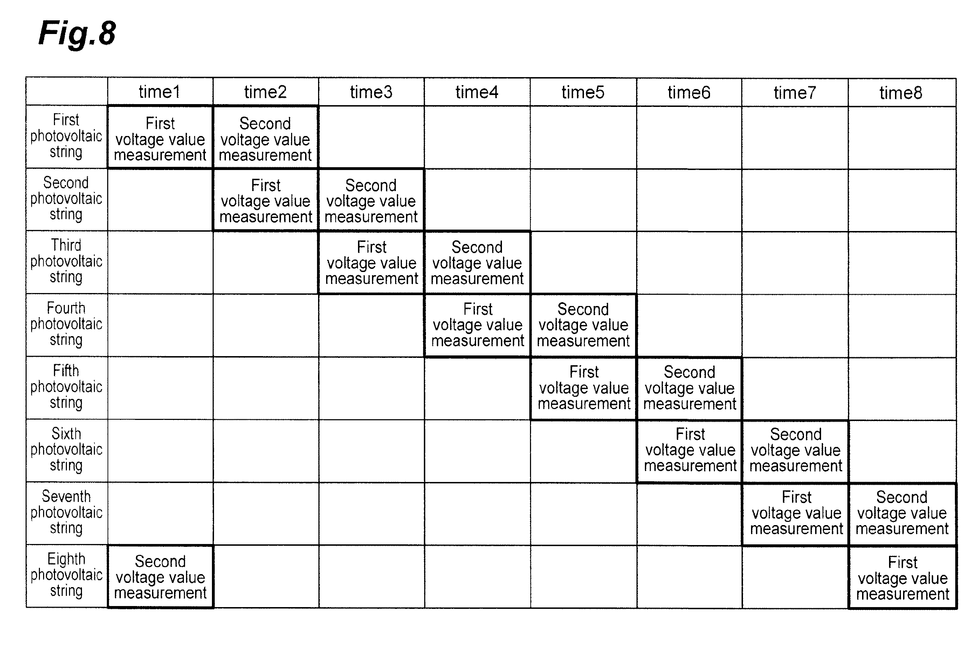

When a ground fault within the photovoltaic array 101 is detected in the ground fault detection device 1 described above, two photovoltaic strings 103 among the plurality of photovoltaic strings 103 are sequentially disconnected from the photovoltaic power generation system 100, for example, as illustrated in an operation scheme of Fig. 8 (a bold frame in Fig. 8). In this case, a measurement of the first voltage value $V_1$ is performed on the one photovoltaic string 103 in a disconnected state, and in parallel therewith, a measurement of the second voltage value $V_2$ is performed on the other photovoltaic string 103 in the disconnected state.

Further, the photovoltaic array 101 including eight photovoltaic strings 103 is illustrated in Fig. 8. Further, states of the ground fault detection device 1 illustrated in Figs. 1 and 2 correspond to states when TIME=1 and 2 in Fig. 8, respectively.

Specifically, when a ground fault within the photovoltaic array 101 is detected, various functions of the calculation control unit 4 are executed to perform the following process. In other words, when i is an integer equal to or more than 1, i=i-n when i>n, and an initial value of i is n, the $i^{th}$ photovoltaic strings $103_n$ to be disconnected from the photovoltaic power generation system 100 is first selected from among the plurality of photovoltaic strings 103, and the disconnection switch elements 7a and 7a corresponding to the $i^{th}$ selected photovoltaic string $103_n$ are turned off to thereby electrically separate and disconnect the $i^{th}$ photovoltaic string $103_n$ from the photovoltaic power generation system 100, resulting in the disconnected state, as illustrated in the flowchart of Fig. 6 (S1).

Subsequently, the $(i+1)^{th}$ photovoltaic string $103_1$ is selected from among the plurality of photovoltaic strings 103, and the disconnection switch elements 7a and 7a corresponding to the $(i+1)^{th}$ selected photovoltaic string $103_1$ are turned off to thereby electrically separate and disconnect the $(i+1)^{th}$ photovoltaic string $103_1$ from the photovoltaic power generation system 100, resulting in the disconnected state (S2).

Subsequently, the measurement switch element 8a corresponding to the one $(i+1)^{th}$ photovoltaic string $103_1$ of the $i^{th}$ and $(i+1)^{th}$ photovoltaic strings $103_n$ and $103_1$ in the disconnected state is turned on to connect the $(i+1)^{th}$

photovoltaic string $103_1$ to the first measurement unit 3A (S3). Also, the first direct current voltage value $Vd_1$ of a negative voltage is applied to the middle point of the photovoltaic string $103_1$ by the first direct current power supply 32A (S4). Accordingly, the photovoltaic string $103_1$ enters the first potential state. In this state, the first voltage value $V_1$ generated in the first resistor 31A is measured by the first voltmeter 33A and a result of the measurement is stored in the storage unit 5 (S5).

Further, in parallel with the process of S3 to S5 described above, the measurement switch element 9a corresponding to the other $i^{th}$ photovoltaic string $103_n$ in the disconnected state is turned on to connect the $i^{th}$ photovoltaic string to the second measurement unit 3B (S6). Also, the second direct current voltage value $Vd_2$ of a positive voltage is applied to the middle point of the photovoltaic string $103_n$ by the second direct current power supply 32B (S7). Accordingly, the photovoltaic string $103_n$ enters the second potential state. In this state, the second voltage value $V_2$ generated in the second resistor 31B is measured by the second voltmeter 33B and a result of the measurement is stored in the storage unit 5 (S8).

Here, the first and second voltage values $V_1$ and $V_2$ are constantly stabilized values. The first and second voltage values $V_1$ and $V_2$ may be values (temporal waveforms or the like) expressed by a function having a time as a variable.

Subsequently, the disconnection switch elements 7a and 7a are turned on for the $i^{th}$ photovoltaic string $103_n$ in the disconnected state to connect the $i^{th}$ photovoltaic string $103_n$ to the photovoltaic power generation system 100, and the measurement switch element 9a is turned off to separate the $i^{th}$ photovoltaic string $103_n$ from the second measurement unit 3B (S9).

Subsequently, when the measurements of the first and second voltage values $V_1$ and $V_2$ (S3 to S6 described above) are not completed for all the photovoltaic strings 103, S2 to S9 described above are repeated with i=i+1 (S10).

On the other hand, when the measurements of the first and second voltage values $V_1$ and $V_2$ are completed for all the photovoltaic strings 103, the disconnection switch elements 7a and 7a are turned on for the $(i+1)^{th}$ photovoltaic string 103 in the disconnected state to connect the photovoltaic string to the photovoltaic power generation system 100, and the measurement switch element 8a is turned off to separate the photovoltaic string from the first measurement unit 3A (S11).

Here, when the first and second voltage values $V_1$ and $V_2$ are stored in the storage unit 5 for each photovoltaic string 103, it is determined whether there is a ground fault in the photovoltaic string 103 based on the first and second voltage values $V_1$ and $V_2$, as illustrated in the flowchart of Fig. 7. In other words, a first leakage current value $I_1$ which is a current value of a leakage current (i.e., a leak current or a zero-phase current) flowing through the first resistor 31A is obtained based on the first voltage value $V_1$. Herewith, a second leakage current value $I_2$ which is a current value of a leakage current flowing through the second resistor 31 B is obtained based on the second voltage value $V_2$, and it is determined whether there is a ground fault from a change in the leakage current values $I_1$ and $I_2$.

Specifically, first, an insulation resistance value $R_{leak}$ is calculated from the first and second leakage current values $I_1$ and $I_2$ using Equation (1) below (S12). Also, the calculated insulation resistance value $R_{leak}$ and a reference resistance value stored in the storage unit 5 in advance are compared to perform a ground fault determination of the photovoltaic array 101 (S13). More specifically, when the insulation resistance value $R_{leak}$ is smaller than the reference resistance value or is equal to or smaller than the reference resistance value, "ground fault" is determined, whereas when the insulation resistance value $R_{leak}$ is equal to or greater than the reference resistance value or is greater than the reference resistance value, "no ground fault" is determined.

$$R_{leak}=(Vd_1-Vd_2)/(I_1-I_2)-Rd \quad \dots \quad (1)$$

Here, Rd: Resistance value of the first and second resistors

Also, if a ground fault determination result in S13 described above is "no ground fault," the disconnection switch elements 7a and 7a are turned on for the photovoltaic string 103 which is a measurement target in the disconnected state to connect the photovoltaic string 103 to the photovoltaic power generation system 100 (S14). On the other hand, if the ground fault determination result is "ground fault," the disconnection switch elements 7a and 7a remain off to be kept in the disconnected state for the photovoltaic string 103 which is a measurement target in the disconnected state (S 15).

As described above, in this embodiment, the photovoltaic string 103 for which the first and second voltage values $V_1$ and $V_2$ are to be measured for ground fault detection is electrically separated and disconnected from the photovoltaic power generation system 100. Thus, since the measurement target is a small unit, the capacitance relative to the ground of the measurement target can be reduced (i.e., an electrical path of the measurement target can be shortened and a total area can be reduced), and adverse effects of a current flowing due to the capacitance relative to a ground on the ground fault detection can be suppressed.

Herewith, the photovoltaic string 103 is electrically separated from the power conditioner 102 at the time of the measurements of the first and second voltage values $V_1$ and $V_2$, thereby suppressing adverse effects of noise generated due to the power conditioner 102 on the measurement. Therefore, it is possible to reliably detect the ground fault.

Further, in this embodiment, separate measurements are performed on the one and other photovoltaic strings 103 and 103 in the disconnected state in parallel (at the same timing), and accordingly the first and second voltage values $V_1$ and $V_2$ are measured in parallel. Thus, it is possible to achieve efficiency of the measurements of the first and second voltage values $V_1$ and $V_2$ and to achieve efficiency of the ground fault detection. Therefore, it is possible to shorten a time required for detection of the ground fault in the photovoltaic array 101 (a total time taken for ground fault detection of the photovoltaic array 101).

Further, in this embodiment, it is possible to suitably detect the ground fault of the photovoltaic string by monitoring the first and second voltage values $V_1$ and $V_2$ generated in the first and second resistors 31A and 31B. Particularly, it can be determined whether there is a ground fault from the change in the first and second voltage values $V_1$ and $V_2$, and therefore it is not necessary for the potential relative to the ground to be generated in the photovoltaic string 103 in order to reliably detect the leakage current value and it is possible to increase safety at the time of ground fault detection.

Further, in this embodiment, since the capacitance relative to a ground of the measurement target can be reduced by detecting the ground fault of the photovoltaic string 103 in the disconnected state, it is possible to suppress concern of an inrush current being generated due to the capacitance relative to a ground when the first and second measurement switches 8 and 9 are switched.

Further, in this embodiment, as many photovoltaic strings 103 as a sum (here, 2) of the number of one photovoltaic string 103 to be measured by the first measurement unit 3A and the number of the other photovoltaic strings 103 to be measured by the second measurement unit 3B are disconnected from the photovoltaic power generation system 100. Thus, only necessary photovoltaic strings 103 can be disconnected and unnecessary disconnection of the photovoltaic strings 103 can be reduced.

Further, in this embodiment, when no ground fault is determined for the disconnected photovoltaic string 103, the photovoltaic string 103 is electrically connected to the photovoltaic power generation system 103, whereas when it is determined that there is a ground fault, the photovoltaic string 103 is left in a state in which the photovoltaic string 103 is disconnected from the photovoltaic power generation system 103, as described above. Thus, it is possible to suitably cause the ground photovoltaic string 103 having no ground fault to contribute to power generation.

Further, in this embodiment, the insulation resistance value $R_{leak}$ is calculated, and it is determined that there is a ground fault when the insulation resistance value $R_{leak}$ is equal to or less than a predetermined value or is less than the predetermined value. When the ground fault is determined from the current value, the current value changes if the potential relative to the ground of the measurement target changes, and therefore the determination may be complicated in some cases. In this regard, since the insulation resistance value $R_{leak}$ does not depend on the potential relative to the ground of the photovoltaic string 103, it possible to easily and suitably perform the determination of whether there is a ground fault.

Further, in this embodiment, when the first measurement unit 3A is connected to the one disconnected photovoltaic string 103, the potential relative to the ground of the one photovoltaic string 103 enters the first potential state, and the first voltage value $V_1$ is measured, and when the second measurement unit 3B is connected to the other disconnected photovoltaic string 103, the potential relative to the ground of the other photovoltaic string 103 enters the second potential state, and the second voltage value $V_2$ is measured. In this case, as the potential relative to the ground of the photovoltaic string 103 is intentionally changed into two types (a plurality) of potential states to detect the ground fault with high sensitivity irrespective of the potential of the ground fault position, it is possible to shorten the time required for the detection of the ground fault.

Further, in this embodiment, a configuration in which the first measurement unit 3A does not include the first direct current power supply 32A (i.e., a configuration in which the first measurement unit 3A applies a direct current voltage of 0 V to the photovoltaic string 103) may be adopted, or a configuration in which the second measurement unit 3B does not include the second direct current power supply 32B (i.e., a configuration in which the second measurement unit 3B applies a direct current voltage of 0 V to the photovoltaic string 103) may be adopted.

Further, in this embodiment, while the configuration in which the direct current voltage is applied to the middle point of the photovoltaic string 103 by the first and second direct current power supplies 32A and 32B, the present invention is not limited thereto, and a configuration in which the direct current voltage is applied to any point of the photovoltaic string 103 may be adopted.

[Second embodiment]

Next, a second embodiment of the present invention will be described. Further, differences between the second embodiment and the first embodiment will be mainly described in the description of the second embodiment.

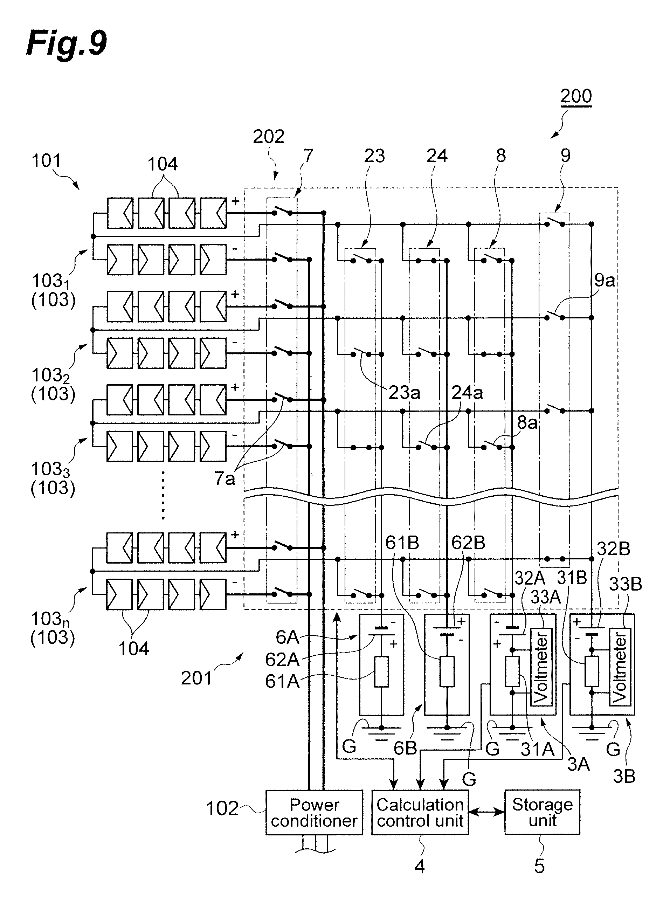

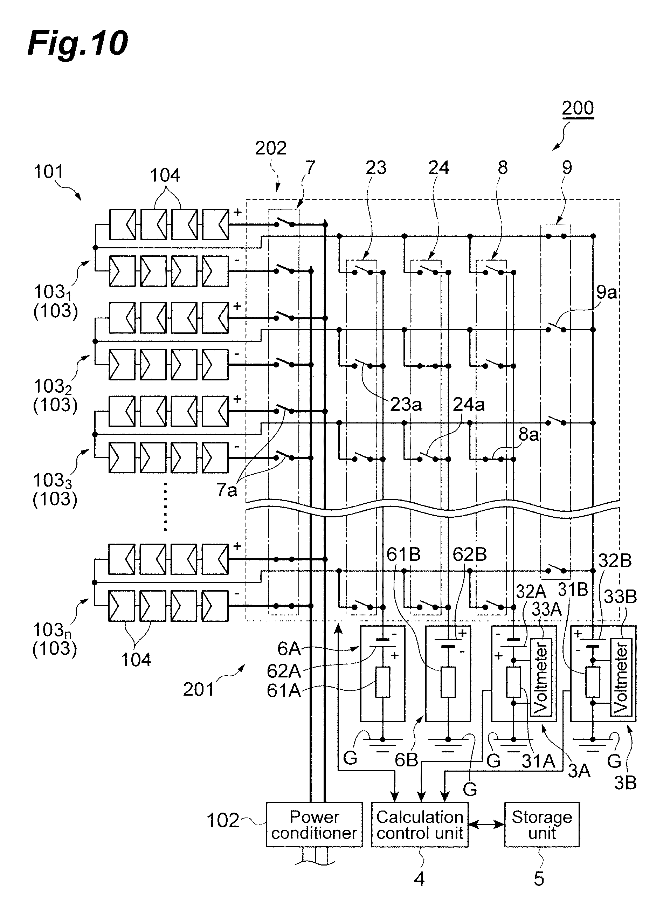

Figs. 9 and 10 are schematic configuration diagrams illustrating a photovoltaic power generation system including a ground fault detection device according to the second embodiment. The ground fault detection device 201 of this embodiment includes a switching unit 202 in place of the switching unit 2 (see Fig. 1), and further includes first and second charging/discharging units 6A and 6B, as illustrated in Figs. 9 and 10.

The switching unit 202 disconnects four photovoltaic strings 103 from the photovoltaic power generation system 200 at the same time. Further, the switching unit 202 connects the photovoltaic string 103 which is in a disconnected state and has not yet been subjected to measurement of the first measurement unit 3A to the first charging/discharging unit 6A, and in parallel therewith, connects the photovoltaic string 103 which is in a disconnected state and has not yet been subjected to measurement of the second measurement unit 3B to the second charging/discharging unit 6B.

This switching unit 202 includes a first charging/discharging switch 23 for connecting the disconnected photovoltaic string 103 to the first charging/discharging unit 6A, and a second charging/discharging switch 24 for connecting the disconnected photovoltaic string 103 to the second charging/discharging unit 6B.

The first charging/discharging switch 23 is located between the photovoltaic string 103 and the first charging/discharging unit 6A and switches electrical connection/non-connection therebetween. The first charging/discharging switch 23 includes a plurality of charging/discharging switch elements 23a connected to a middle point of each photovoltaic string 103. The charging/discharging switch element 23a is connected to the calculation control unit 4, and performs ON/OFF switching according to an instruction signal from the calculation control unit 4. The charging/discharging switch element 23a herein is usually turned off to enter an electrically blocked state, but is turned on to enter an electrically connected state at the time of charging/discharging.

Further, terminals on the first charging/discharging unit 6A side in the plurality of charging/discharging switch elements 23a are connected to form a bus, and this bus is connected to the first charging/discharging unit 6A. A semiconductor switch such as an FET or a mechanical switch such as a relay switch may be used as the charging/discharging switch element 23a.

In the first charging/discharging switch 23 configured in this way, when the four photovoltaic strings 103 are disconnected from the photovoltaic power generation system 200 by the disconnection switch 7, the charging/discharging switch element 23a in one of the photovoltaic strings 103 and 103 which are not electrically connected to the first and second measurement units 3A and 3B among the above photovoltaic strings is turned on. Accordingly, the one photovoltaic string 103 is chargeable/dischargeable in the first charging/discharging unit 6A.

The second charging/discharging switch 24 is located between the photovoltaic string 103 and the second charging/discharging unit 6B and switches electrical connection/non-connection therebetween. The second charging/discharging switch 24 includes a plurality of charging/discharging switch elements 24a connected to the middle point of each photovoltaic string 103. The charging/discharging switch element 24a is connected to the calculation control unit 4, and performs ON/OFF switching according to an instruction signal from the calculation control unit 4. The charging/discharging switch element 24a herein is usually turned off to enter an electrically blocked state, but is turned on to enter an electrically connected state at the time of charging/discharging.

Further, terminals on the second charging/discharging unit 6B side of the plurality of charging/discharging switch elements 24a are connected to form a bus, and this bus is connected to the second charging/discharging unit 6B. A semiconductor switch such as an FET or a mechanical switch such as a relay switch may be used as the charging/discharging switch element 24a.

In the second charging/discharging switch 24 configured in this way, when the four photovoltaic strings 103 are disconnected from the photovoltaic power generation system 100 by the disconnection switch 7, the charging/discharging switch element 24a in the other of the photovoltaic strings 103 and 103 which are not electrically connected to the first and second measurement units 3A and 3B among the above photovoltaic strings is turned on. Accordingly, the other photovoltaic string 103 is chargeable/dischargeable in the second charging/discharging unit 6B.

The first charging/discharging unit 6A connects to the disconnected photovoltaic string 103 so that its potential relative to the ground is the same as the potential relative to the ground when the photovoltaic string is connected to the first measurement unit 3A. Accordingly, charging/discharging (charging or discharging) is performed in the first charging/discharging unit 6A so that a charge amount in a capacitance relative to a ground of the photovoltaic string 103 is the same as a capacitance relative to a ground charge amount when the photovoltaic string is connected to the first measurement unit 3A.

Specifically, the first charging/discharging unit 6A includes a first resistor 61A having one side connected to the ground potential G, and a first direct current power supply 62A connected to the other side of the first resistor 61A. The first resistor 61A is provided between the switching unit 202 and the ground potential G on an electrical path. A resistance value of the first resistor 61A is the same as the resistance value of the first resistor 31A. The first direct current power supply 62A is provided between the switching unit 202 and the first resistor 61A on the electrical path. The first direct current power supply 62A applies a direct current voltage having a negative voltage to the middle point of the photovoltaic string 103. Here, the first direct current power supply 62A applies the direct current voltage having the first direct current voltage value $Vd_1$ as the first direct current power supply 32A. In this way, the photovoltaic string 103 enters the first potential state. The first direct current power supply 62A is connected to the calculation control unit 4, and applies the direct current voltage having the first direct current voltage value $Vd_1$ according to an instruction signal from the calculation control unit 4.

The second charging/discharging unit 6B connects to the disconnected photovoltaic string 103 so that its potential relative to the ground is the same as the potential relative to the ground when the photovoltaic string is connected to the second measurement unit 3B. Accordingly, the charging/discharging is performed in the second charging/discharging unit 6B so that a charge amount in a capacitance relative to a ground of the photovoltaic string 103 is the same as a capacitance relative to a ground charge amount when the photovoltaic string is connected to the second measurement unit 3B.

Specifically, the second charging/discharging unit 6B includes a second resistor 61B having one side connected to the ground potential G, and a second direct current power supply 62B connected to the other side of the second resistor 61B. The second resistor 61B is provided between the switching unit 202 and the ground potential G on an electrical path. A resistance value of the second resistor 61B is the same as the resistance value of the second resistor 31B. The second direct current power supply 62B is provided between the switching unit 202 and the second resistor 61B on the electrical path. The second direct current power supply 62B applies a direct current voltage of a positive voltage to the middle point of the photovoltaic string 103. Here, the second direct current power supply 62B applies the same direct current voltage having the second direct current voltage value $Vd_2$ as the second direct current power supply 32B. Accordingly, the photovoltaic string 103 enters the second potential state. The second direct current power supply 62B is connected to the calculation control unit 4, and applies the direct current voltage having the second direct current voltage value $Vd_2$ according to an instruction signal from the calculation control unit 4.

Further, the calculation control unit 4 further has a charging/discharging function for instructing the charging/discharging switches 23 and 24 of the switching unit 202 to perform ON/OFF switching to thereby instruct the photovoltaic string 103 in the disconnected state to perform charging/discharging.

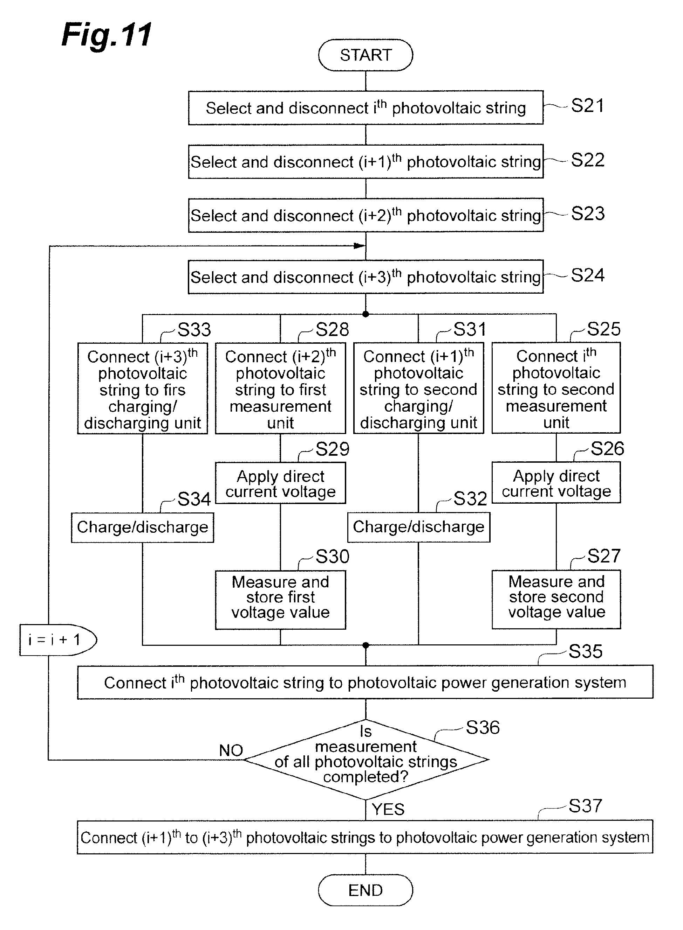

Next, an example of a ground fault detection method (operation of the ground fault detection program) performed by the ground fault detection device 201 will be illustrated and described with reference to a flowchart illustrated in Fig. 11.

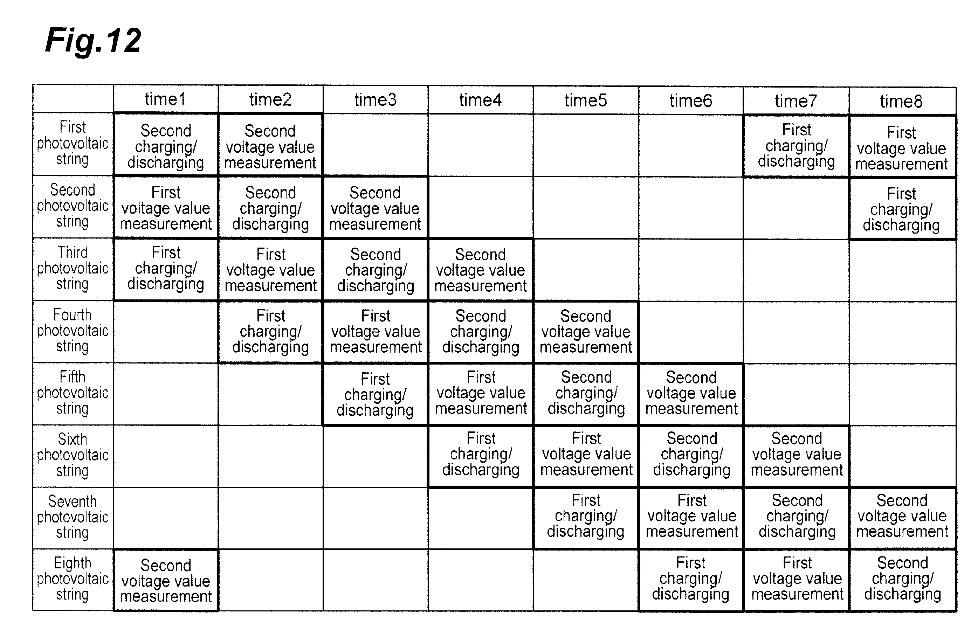

In such an embodiment, when a ground fault within the photovoltaic array 101 is detected, four photovoltaic strings 103 among the plurality of photovoltaic strings 103 are sequentially disconnected from the photovoltaic power generation system 200, as illustrated in the operation scheme of Fig. 12 (a bold frame in Fig. 12). In this case, the first measurement unit 3A is connected to the photovoltaic string 103 in the disconnected state to measure the first voltage value $V_1$, and in parallel therewith, the second measurement unit 3B is connected to the separate photovoltaic string 103 in the disconnected state to measure the second voltage value $V_2$. Herewith, the first charging/discharging unit 6A is connected to the photovoltaic string 103 which is in a disconnected state and has not yet been subjected to the measurement of the first measurement unit 3A to charge/discharge the photovoltaic string (first charging/discharging), and in parallel therewith, the second charging/discharging unit 6B is connected to the photovoltaic string 103 which is in the disconnected state and has not yet been subjected to measurement of the second measurement unit 3B to charge/discharge the photovoltaic string (second charging/discharging).

Further, a photovoltaic array 101 including eight photovoltaic strings 103 is illustrated in Fig. 12. Further, states of the ground fault detection device 201 illustrated in Figs. 9 and 10 correspond to states when TIME=1 and 2 in Fig. 12, respectively.

Specifically, when i is an integer equal to or more than 1, i=i-n when i>n, and an initial value of i is n, first, the $i^{th}$ photovoltaic string $103_n$ is selected and disconnected from the photovoltaic power generation system 200, the $(i+1)^{th}$ photovoltaic string $103_1$ is selected and disconnected from the photovoltaic power generation system 200, the $(i+2)^{th}$ photovoltaic string $103_2$ is selected and disconnected from the photovoltaic power generation system 200, and the $(i+3)^{th}$ photovoltaic string $103_3$ is selected and disconnected from the photovoltaic power generation system 100, as illustrated in the flowchart of Fig. 11 (S21 to S24).

Subsequently, the measurement switch element 9a corresponding to the $i^{th}$ photovoltaic string $103_n$ among the photovoltaic strings 103 in the disconnected state is turned on to connect the $i^{th}$ photovoltaic string $103_n$ to the second measurement unit 3B (S25). Also, the second direct current voltage value $Vd_2$ of a negative voltage is applied to the middle point of the photovoltaic string $103_n$ by the second direct current power supply 32B (S26). Accordingly, the photovoltaic string $103_n$ enters the second potential state. In this state, the second voltage value $V_2$ generated in the second resistor 31B is measured by the second voltmeter 33B, and a result of the measurement is stored in the storage unit 5 (S27).

Further, in parallel with the process of S25 to S27 described above, the measurement switch element 8a corresponding to the $(i+2)^{th}$ photovoltaic string $103_2$ among the photovoltaic strings 103 in the disconnected state is turned on to connect the $(i+2)^{th}$ photovoltaic string $103_2$ to the first measurement unit 3A (S28). Also, the first direct current voltage value $Vd_1$ of the positive voltage is applied to the middle point of the photovoltaic string $103_2$ by the first direct current power supply 32A (S29). Accordingly, the photovoltaic string $103_2$ enters the first potential state. In this state, the first voltage value $V_1$ generated in the first resistor 31A is measured by the first voltmeter 33A, and a result of the measurement is stored in the storage unit 5 (S30).

Further, in parallel with the process of S25 to S30 described above, the filling switch element 24a corresponding to the $(i+1)^{th}$ photovoltaic string $103_1$ among the photovoltaic strings 103 in the disconnected state is turned on to connect the $(i+1)^{th}$ photovoltaic string $103_1$ to the second charging/discharging unit 6B to cause the photovoltaic string $103_1$ to enter the second potential state (S31). Accordingly, charging/discharging is performed by the second charging/discharging unit 6B until an amount of charges stored in a capacitance relative to a ground of the $(i+1)^{th}$ photovoltaic string $103_1$ is the same as an amount of charges stored in a capacitance relative to a ground when the photovoltaic string is connected to the second measurement unit 3B (S32).

Further, in parallel with the process of S25 to S32 described above, the filling switch element 23a corresponding to the $(i+3)^{th}$ photovoltaic string $103_3$ among the photovoltaic strings 103 in the disconnected state is turned on to connect the $(i+3)^{th}$ photovoltaic string $103_3$ to the first charging/discharging unit 6A to cause the photovoltaic string $103_3$ to enter the first potential state (S33). Accordingly, charging/discharging is performed by the first charging/discharging unit 6A until an amount of charges stored in a capacitance relative to a ground of the $(i+3)^{th}$ photovoltaic string $103_3$ is the same as an amount of charges stored in a capacitance relative to a ground when the photovoltaic string is connected to the first measurement unit 3A (S34).

Subsequently, the disconnection switch elements 7a and 7a are turned on for the $i^{th}$ photovoltaic string $103_n$ in the disconnected state to connect the photovoltaic string to the photovoltaic power generation system 200, and the measurement switch element 9a is turned off to separate the photovoltaic string from the second measurement unit 3B (S35).

Subsequently, S24 to S35 described above are repeated with i=i+1 until the measurements of first and second voltage values $V_1$ and $V_2$ are completed for all the photovoltaic strings 103 (S36). When the measurements of the voltage values $V_1$ and $V_2$ are completed for all the photovoltaic strings 103, the disconnection switch elements 7a and 7a are turned on for the $(i+1)^{th}$ to $(i+3)^{th}$ photovoltaic strings 103 in the disconnected state to connect the photovoltaic strings to the photovoltaic power generation system 200, and the measurement switch element 8a and the charging/discharging switch elements 23a and 24a are turned off to separate the photovoltaic strings (S37).

Further, when the voltage values $V_1$ and $V_2$ are stored in the storage unit 5 for each photovoltaic string 103, it is determined whether there is a ground fault of the photovoltaic string 103 based on the voltage values $V_1$ and $V_2$, as in the procedure illustrated in the flowchart of Fig. 7

As described above, in this embodiment, the one and other photovoltaic strings 103 and 103 for which the voltage values $V_1$ and $V_2$ are to be measured can be disconnected from the photovoltaic power generation system 200. Further, it is possible to achieve efficiency of the ground fault detection since separate measurements can be performed in parallel on the one and other photovoltaic strings 103 and 103 in the disconnected state. Thus, the action effects described above, i.e., action effects of reliably detecting the ground fault and shortening a time required for detection of the ground fault, are achieved.

Here, generally, since the first and second measured voltage values $V_1$ and $V_2$ may vary due to the capacitance relative to a ground of the photovoltaic string 103 immediately after the measurement switch elements 8a and 9a in the photovoltaic string 103 are turned on to connect the photovoltaic string 103 to the first and second measurement units 3A and 3B, usually, it is necessary to wait until such a variation is settled before execution of the measurement according to the ground fault detection.

In this regard, in this embodiment, the photovoltaic strings 103 and 103 before the first and second voltage values $V_1$ and $V_2$ are measured can be charged/discharged in advance, in parallel with measuring the first and second voltage values $V_1$ and $V_2$ for the photovoltaic strings 103 and 103 in the disconnected state, as described above. Thus, the variation of the first and second measured voltage values $V_1$ and $V_2$ can be suppressed and such measurement can be performed without waiting immediately after the first and the second measurement units 3A and 3B are connected to the photovoltaic string 103. Therefore, it is possible to shorten the time required for detection of the ground fault in the photovoltaic array 101.

[Third embodiment]

Next, a third embodiment of the present invention will be described. Further, differences between this embodiment and the first embodiment will be mainly described in the description of the third embodiment.

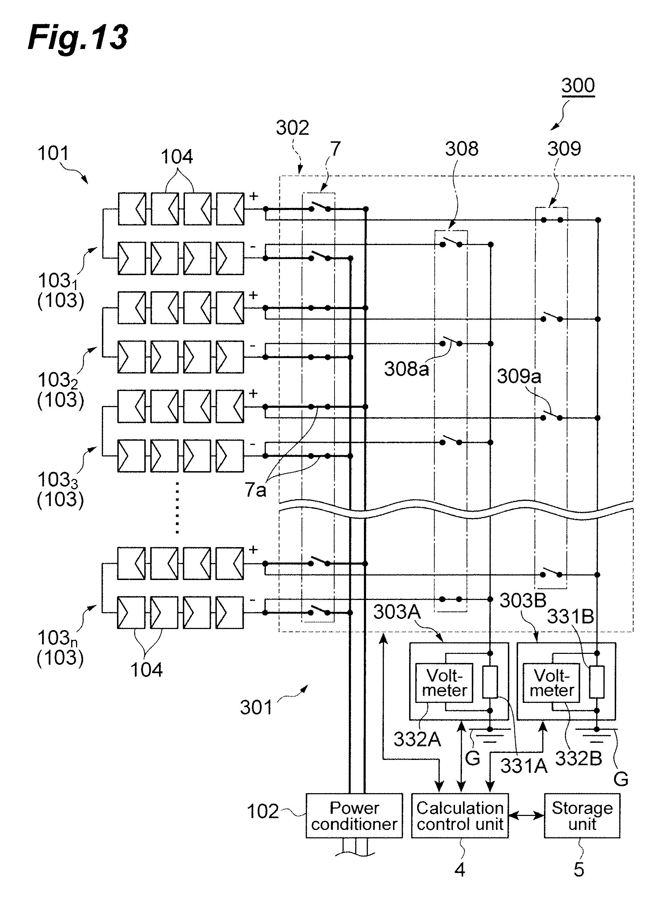

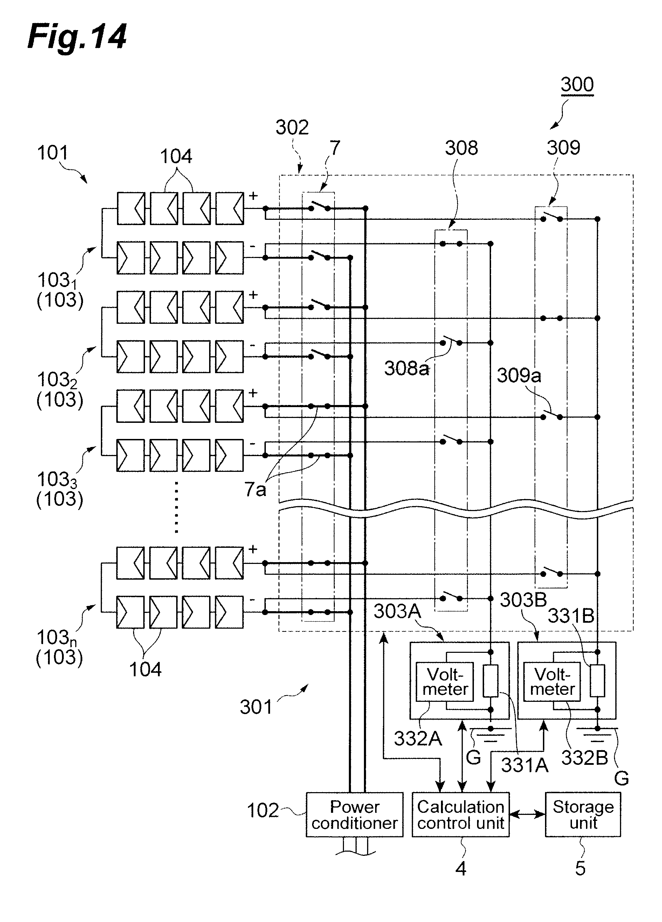

Figs. 13 and 14 are schematic configuration diagrams illustrating a photovoltaic power generation system including a ground fault detection device according to the third embodiment. The ground fault detection device 301 of this embodiment includes a switching unit 302 in place of the switching unit 2 (see Fig. 1), and the first and second measurement units 303A and 303B in place of the first and second measurement units 3A and 3B, as illustrated in Figs. 13 and 14.

The switching unit 302 includes a first measurement switch 308 in place of the first measurement switch 8 and includes a second measurement switch 309 in place of the second measurement switch 9. The first measurement switch 308 is located between the photovoltaic string 103 and the first measurement unit 303A, switches electrical connection/non-connection therebetween, and includes a measurement switch element 308a connected to the negative electrode side of each photovoltaic string 103. The measurement switch element 308a is connected to the calculation control unit 4, and performs ON/OFF switching according to an instruction signal from the calculation control unit 4. The measurement switch element 308a herein is usually turned off to enter an electrically blocked state, but is turned on to enter an electrically connected state at the time of measurement.

The second measurement switch 309 is located between the photovoltaic string 103 and the second measurement unit 303B, switches electrical connection/non-connection therebetween, and includes a measurement switch element 309a connected to the positive electrode side of each photovoltaic string 103. The measurement switch element 309a is connected to the calculation control unit 4, and performs ON/OFF switching according to an instruction signal from the calculation control unit 4. The measurement switch element 309a herein is usually turned off to enter an electrically blocked state, but is turned on to enter an electrically connected state at the time of measurement.

The first measurement unit 303A includes a first resistor 331A having one side connected to the ground potential G, and a first voltmeter 332A which measures a voltage generated in the first resistor 331A. The first resistor 331A has the other side electrically connectable to the negative electrode bus of the photovoltaic string 103 through the first measurement switch 308. The first resistor 331A has a resistance value which is a resistance value Rd.

The first voltmeter 332A is electrically connected between the switching unit 302 and the first resistor 331A and between the first resistor 331A and the ground potential G, and measures a voltage drop value and its sign of the first resistor 331A. Here, the first voltmeter 332A measures the voltage drop value as a negative electrode-side voltage drop value (a second measurement value) $V_3$. Further, a sign of the voltage drop value may be set, for example, in such a manner that a direction in which a current flows towards the ground potential G is positive, and a reverse direction is negative.

Further, the first voltmeter 332A measures a potential difference between the positive electrode and the negative electrode of the disconnected photovoltaic string 103 (hereinafter referred to as an "inter-electrode voltage value") and its sign. The sign of the inter-electrode voltage value may be set, for example, by comparing a magnitude of the positive electrode-side potential and a magnitude of the negative electrode-side potential. The first voltmeter 332A is connected to the calculation control unit 4, and performs various measurements according to an instruction signal from the calculation control unit 4, and a result of the measurement is stored in the storage unit 5.

The second measurement unit 303B includes a second resistor 331B having one side connected to the ground potential G, and a second voltmeter 332B which measures a voltage generated in the second resistor 331B. The second resistor 331B includes the other side electrically connectable to the positive electrode bus of the photovoltaic string 103 through the second measurement switch 309. The second resistor 331B has a resistance value which is a resistance value Rd equal to that of the first resistor 331A.

The second voltmeter 332B is electrically connected between the switching unit 302 and the second resistor 301B and between the second resistor 301B and the ground potential G, and measures a voltage drop value and its sign of the second resistor 301B. Here, the second voltmeter 332B measures a voltage drop value as a positive electrode-side voltage drop value (a first measurement value) $V_4$. Further, the second voltmeter 332B measures an inter-electrode voltage value and its sign of the disconnected photovoltaic string 103. The second voltmeter 332B is connected to the calculation control unit 4 and performs various measurements according to an instruction signal from the calculation control unit 4, and a result of the measurement is stored in the storage unit 5.

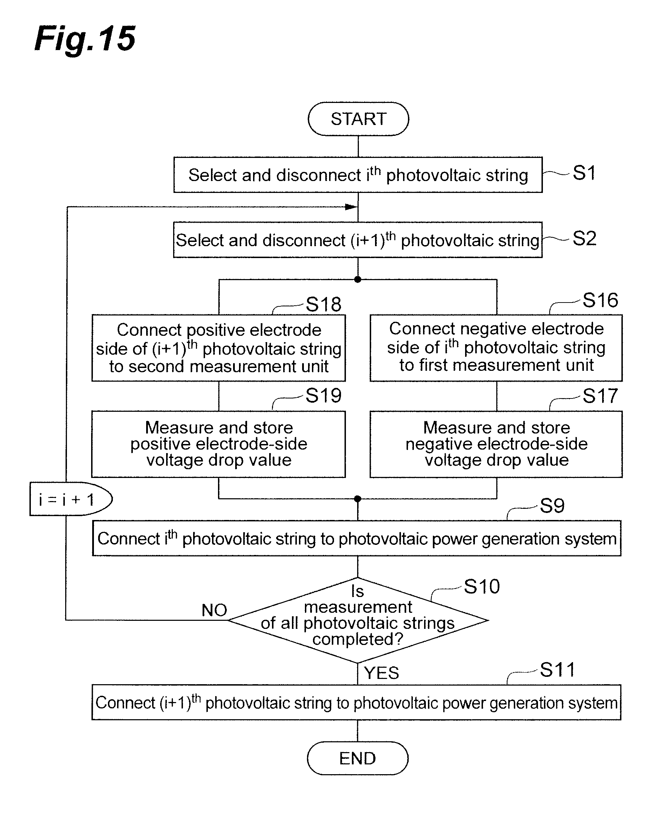

Next, an example of a ground fault detection method (operation of the ground fault detection program) performed by the ground fault detection device 301 will be illustrated and described with reference to a flowchart illustrated in Fig. 15.

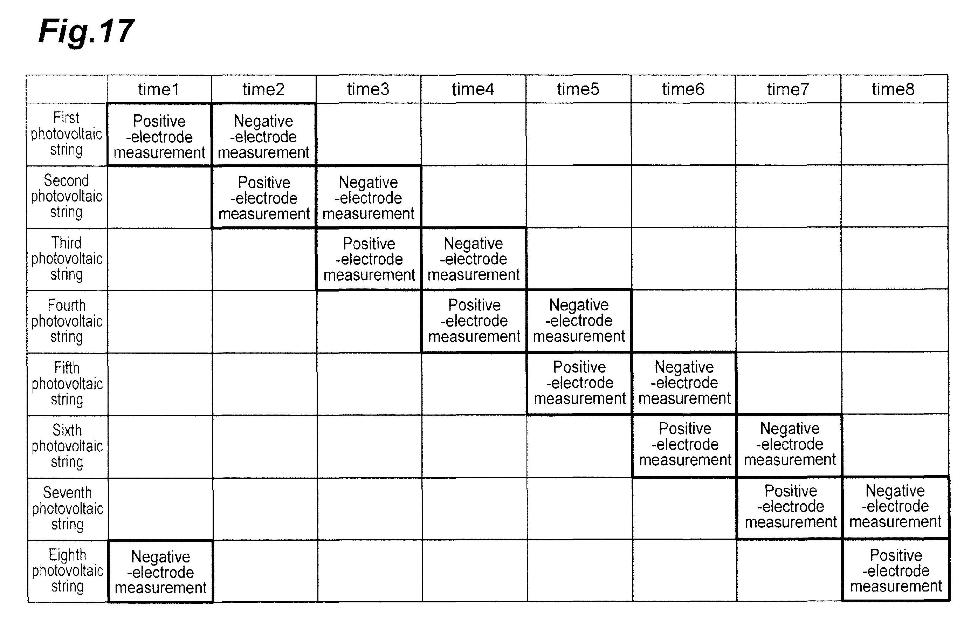

In such an embodiment, when a ground fault within the photovoltaic array 101 is detected, two photovoltaic strings 103 among a plurality of photovoltaic strings 103 are sequentially disconnected from the photovoltaic power generation system 300, for example, as illustrated in an operation scheme of Fig. 17 (a bold frame in Fig. 17). In this case, the first measurement unit 303A is connected to the negative electrode side in the one photovoltaic string 103 in the disconnected state to cause the negative electrode side to enter the first potential state, and measure the negative electrode-side voltage drop value $V_3$ of the first resistor 331A.

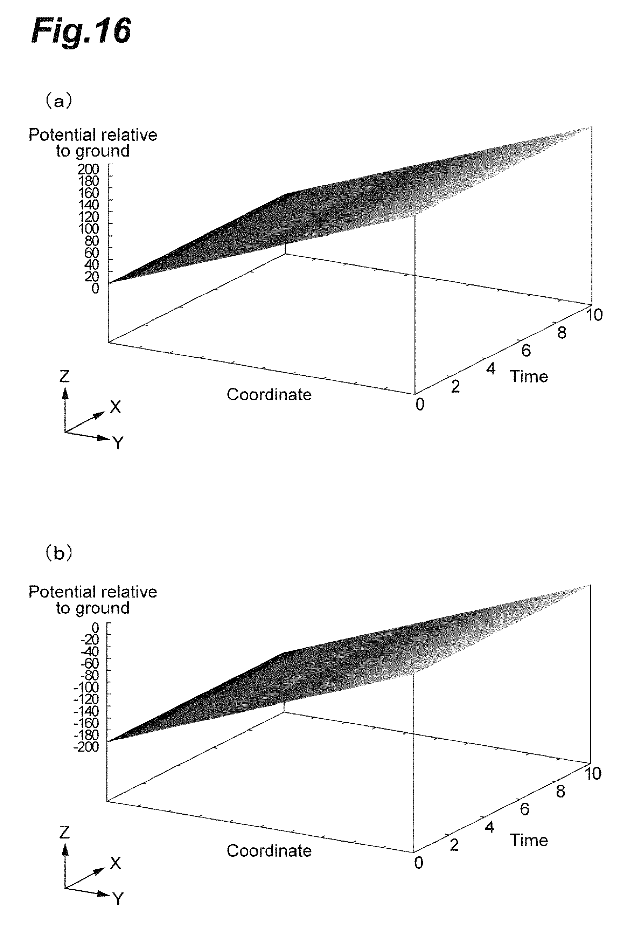

The first potential state of this embodiment is a state in which the potential relative to the ground of each coordinate of the photovoltaic string 103 is stabilized as the state illustrated in Fig. 16(a) from a time when the first measurement unit 303A is connected to the negative electrode side of the photovoltaic string 103. In other words, for example, in the photovoltaic string 103 of the voltage value of 200 V, the potential relative to the ground on the negative electrode side becomes the same potential (= 0 V) as the ground potential, and the potential relative to the ground increases up to 200 V from the negative electrode side to the positive electrode side (i.e., the potential relative to the ground of each coordinate is translated in a Z-axis direction so that the negative electrode side becomes 0 V).

In parallel therewith, the second measurement unit 303B is connected to the positive electrode side in the other photovoltaic string 103 in the disconnected state to cause the positive electrode side to enter the second potential state, and measures the positive electrode-side voltage drop value $V_4$ of the second resistor 331B. The second potential state of this embodiment is a potential state different from the first potential state. The second potential state herein is a state in which the potential relative to the ground of each coordinate of the photovoltaic string 103 is stabilized as the state illustrated in Fig. 16(b) from a time when the second measurement unit 303B is connected to the positive electrode side of the photovoltaic string 103. In other words, for example, in the photovoltaic string 103 of the voltage value of 200 V, the potential relative to the ground on the positive electrode side becomes the same potential (= 0 V) as the ground potential, and the potential relative to the ground decreases up to -200 V from the positive electrode side to the negative electrode side (i.e., the potential relative to the ground of each coordinate is translated in a Z-axis direction so that the positive electrode side becomes 0 V).

Further, the photovoltaic array 101 including eight photovoltaic strings 103 is illustrated in Fig. 17. Further, the states of the ground fault detection device 301 illustrated in Figs. 13 and 14 correspond to states when TIME=1 and 2 in Fig. 17, respectively.

Specifically, when i is an integer equal to or more than 1, i=i-n when i>n, and an initial value of i is n, the measurement switch element 308a is turned on for the one $i^{th}$ photovoltaic string $103_n$ among the photovoltaic strings $103_n$ and $103_1$ in the disconnected state to connect the negative electrode side to the first measurement unit 303A after the $(i+1)^{th}$ photovoltaic string $103_1$ is selected and disconnected from the photovoltaic power generation system 300 (after S2 described above) (S16), as illustrated in the flowchart of Fig. 15. In this state, the negative electrode-side voltage drop value $V_3$ and its sign of the $I^{th}$ photovoltaic string $103_n$ are measured by the first voltmeter 332A, and a result of the measurement is stored in the storage unit 5 (S17).

In parallel with the process of S16 and S17, the measurement switch element 309a is turned on for the other $(i+1)^{th}$ photovoltaic string $103_1$ in the disconnected state to connect the positive electrode side to the second measurement unit 303B (S18). In this state, the positive electrode-side voltage drop value $V_4$ and its sign of the $(i+1)^{th}$ photovoltaic string $103_1$ are measured by the second voltmeter 332B, and a result of the measurement is stored in the storage unit 5 (S 19). Also, the process proceeds to S10 described above to perform a determination as to whether or not the measurement (S16 to S19 described above) of the voltage drop values $V_3$ and $V_4$ is completed for all the photovoltaic strings 103.

Further, when the voltage drop values $V_3$ and $V_4$ are stored in the storage unit 5 for each photovoltaic string 103, it is determined whether there is a ground fault of the photovoltaic string 103 based on the voltage drop values $V_3$ and $V_4$, as in the procedure illustrated in the flowchart of Fig. 7. In other words, as S12 described above, the inter-electrode voltage value and its sign of the photovoltaic string 103 are further measured and the insulation resistance value $R_{leak}$ is calculated using Equation (3) below. The process then proceeds to S13 described above to perform the ground fault determination of the photovoltaic array 101.

$$R_{leak} = Rd \times |V_0/(V3-V4)|) - Rd \quad \ldots \quad (3)$$

Here, $V_0$: Inter-electrode voltage value

Here, the voltage drop values $V_3$ and $V_4$ are constantly stabilized values. These voltage drop values $V_3$ and $V_4$ may be values (temporal waveforms or the like) expressed as a function having a time as a variable.

As described above, in this embodiment, the one and other photovoltaic strings 103 and 103 for which the voltage drop values $V_3$ and $V_4$ are to be measured can be disconnected from the photovoltaic power generation system 300. Further, since separate measurements can be performed on the one and other photovoltaic strings 103 and 103 in the disconnected state in parallel, it is possible to achieve efficiency of the ground fault detection. Thus, the action effects described above, i.e., action effects of reliably detecting the ground fault and shortening a time required for detection of the ground fault, are achieved.

Further, in this embodiment, it is possible to suitably detect a ground fault within the photovoltaic array by monitoring each of the voltage drop values $V_3$ and $V_4$. Particularly, in this embodiment, since it is determined whether there is a ground fault based on the insulation resistance value $R_{leak}$ obtained by measuring the voltage drop values $V_3$ and $V_4$ and performing the calculation instead of monitoring the zero-phase current to detect a ground fault, as described above, it is possible to suitably detect failure of insulation relative to the ground in advance. Further, it is possible to detect a ground fault point from a balance of the voltage drop values $V_3$ and $V_4$.

[Fourth embodiment]

Next, a fourth embodiment of the present invention will be described. Further, differences between the fourth embodiment and the third embodiment will be mainly described in the fourth embodiment.

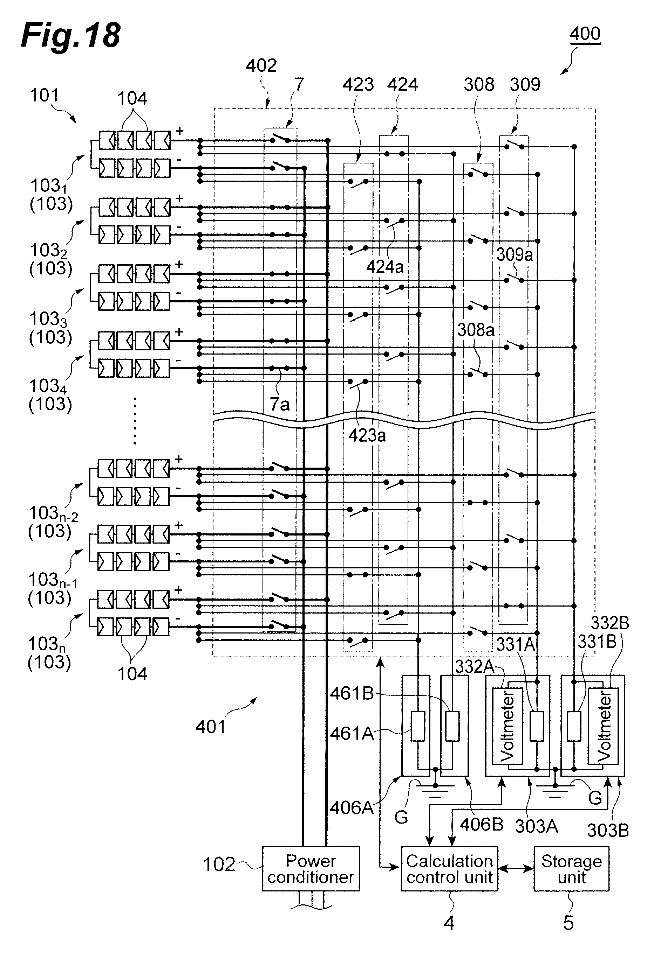

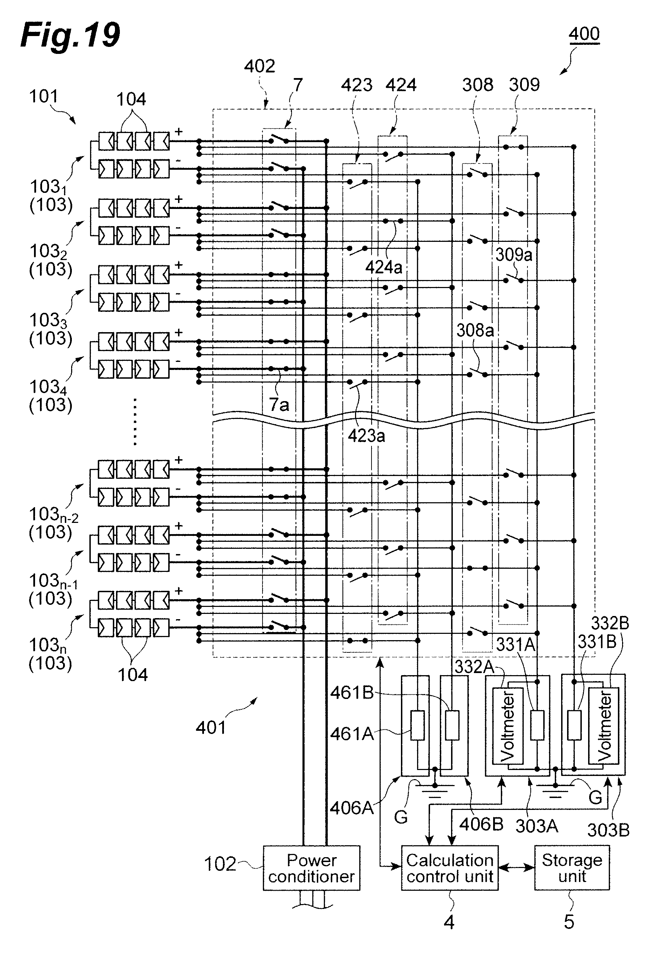

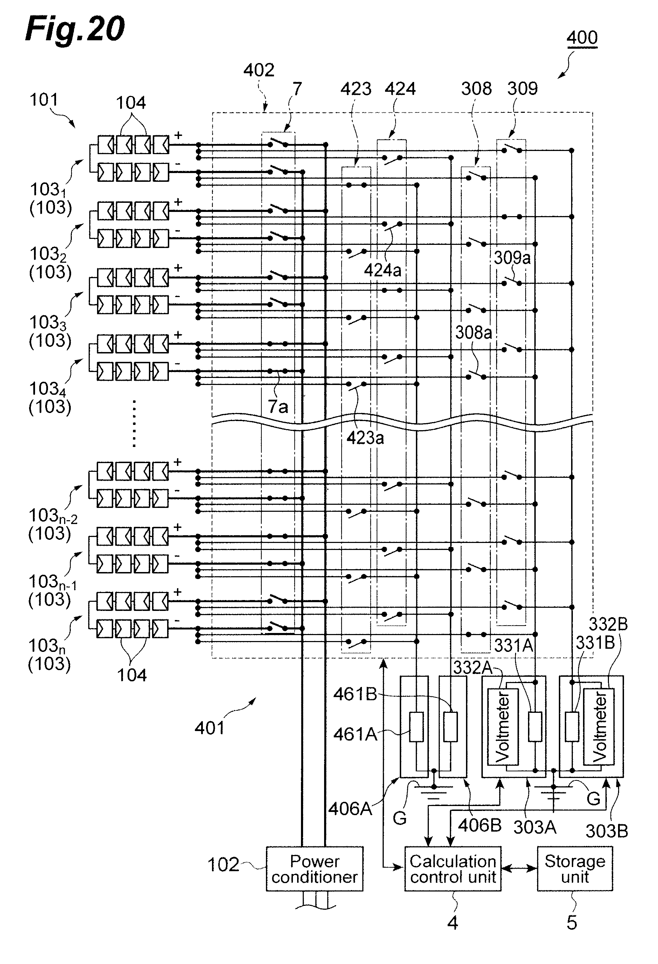

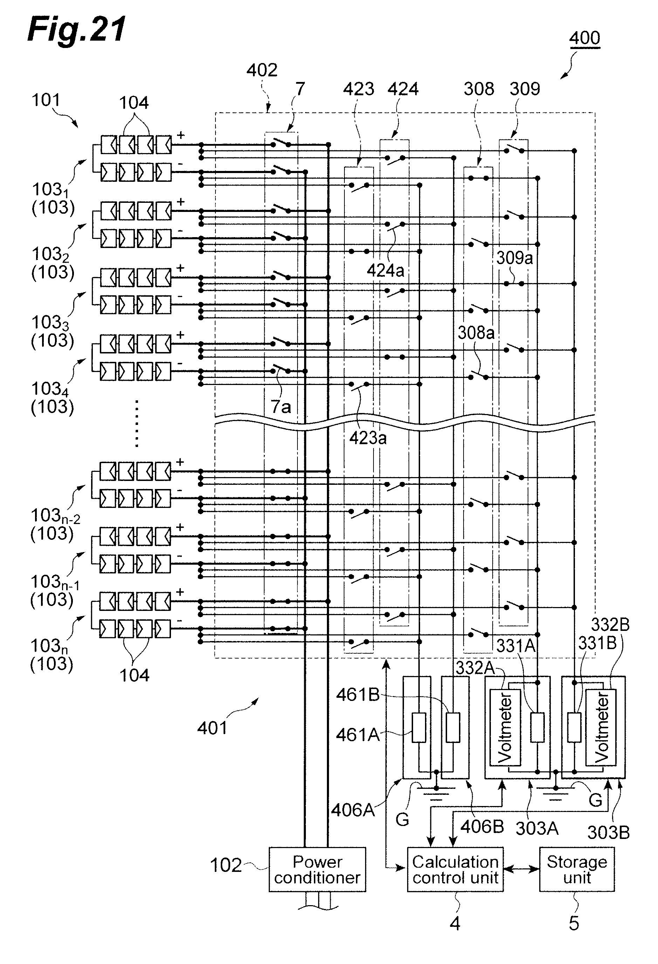

Figs. 18 to 21 are schematic configuration diagrams illustrating a photovoltaic power generation system including a ground fault detection device according to the fourth embodiment. The ground fault detection device 401 of this embodiment includes a switching unit 402 in place of the switching unit 302 (see Fig. 13) and further includes first and second charging/discharging units 406A and 406B, as illustrated in Figs. 18 to 21.

The switching unit 402 disconnects four photovoltaic strings 103 from the photovoltaic power generation system 400 at the same time. Further, the switching unit 402 connects the photovoltaic string 103 which is in a disconnected state and has not yet been subjected to measurement of the first measurement unit 303A to the first charging/discharging unit 406A, and in parallel therewith, connects the photovoltaic string 103 which is in a disconnected state and has not yet been subjected to measurement of the second measurement unit 303B to the second charging/discharging unit 406B.

This switching unit 402 includes a first charging/discharging switch 423 for connecting the disconnected photovoltaic string 103 to the first charging/discharging unit 406A, and a second charging/discharging switch 424 for connecting the disconnected photovoltaic string 103 to the second charging/discharging unit 406B.

The first charging/discharging switch 423 is located between the photovoltaic string 103 and the first charging/discharging unit 406A and switches electrical connection/non-connection therebetween. The first charging/discharging switch 423 includes a plurality of charging/discharging switch elements 423a connected to the negative electrode side of each photovoltaic string 103. The charging/discharging switch element 423a is connected to the calculation control unit 4, and performs ON/OFF switching according to an instruction signal from the calculation control unit 4. The charging/discharging switch element 423a herein is usually turned off to enter an electrically blocked state, but is turned on to enter an electrically connected state at the time of charging/discharging.

Further, terminals on the first charging/discharging unit 406A side of the plurality of charging/discharging switch elements 423a are connected to form a negative electrode bus. This negative electrode bus is connected to the first charging/discharging unit 406A. A semiconductor switch such as an FET or a mechanical switch such as a relay switch may be used as the charging/discharging switch element 423 a.

In the first charging/discharging switch 423 configured in this way, when four photovoltaic strings 103 are disconnected from the photovoltaic power generation system 400 by the disconnection switch 7, the charging/discharging switch element 423a in the one of the photovoltaic strings 103 and 103 which are not electrically connected to the first and second measurement units 403A and 403B among the above the photovoltaic strings is turned on. Accordingly, the one photovoltaic string 103 is chargeable/dischargeable in the first charging/discharging unit 406A.

The second charging/discharging switch 424 is located between the photovoltaic string 103 and the second charging/discharging unit 406B and switches electrical connection/non-connection therebetween. The second charging/discharging switch 424 includes a plurality of charging/discharging switch elements 424a connected to the positive electrode side of each photovoltaic string 103. The charging/discharging switch element 424a is connected to the calculation control unit 4, and performs ON/OFF switching according to an instruction signal from the calculation control unit 4. The charging/discharging switch element 424a herein is usually turned off to enter an electrically blocked state, but is turned on to enter an electrically connected state at the time of charging/discharging.

Further, terminals on the second charging/discharging unit 406B side of the plurality of charging/discharging switch elements 424a are connected to form a positive electrode bus. This positive electrode bus is connected to the second charging/discharging unit 406B. A semiconductor switch such as an FET or a mechanical switch such as a relay switch may be used as the charging/discharging switch element 424a.

In the second charging/discharging switch 424 configured in this way, when four photovoltaic strings 103 are disconnected from the photovoltaic power generation system 400 by the disconnection switch 7, the charging/discharging switch element 424a in the other of the photovoltaic strings 103 and 103 which are not electrically connected to the first and second measurement units 303A and 303B among the above photovoltaic strings is turned on. Accordingly, the other photovoltaic string 103 is chargeable/dischargeable in the second charging/discharging unit 406B.

The first charging/discharging unit 406A connects to the disconnected photovoltaic string 103 to cause the photovoltaic string to enter the first potential state so that the potential relative to the ground of the photovoltaic string 103 is the same as the potential relative to the ground when the photovoltaic string is connected to the first measurement unit 303A. Accordingly, charging/discharging is performed in the first charging/discharging unit 406A so that a charge amount in a capacitance relative to a ground of the photovoltaic string 103 is the same as a capacitance relative to a ground charge amount when the photovoltaic string is connected to the first measurement unit 303A. The first charging/discharging unit 406A includes a first resistor 461A having one side connected to the ground potential G. A resistance value of the first resistor 461A is the same as a resistance value of the first resistor 331A of the first measurement unit 303A.

The second charging/discharging unit 406B connects to the disconnected photovoltaic string 103 to cause the photovoltaic string to enter the second potential state so that the potential relative to the ground of the photovoltaic string 103 is the same as the potential relative to the ground when the photovoltaic string 103 is connected to the second measurement unit 303B. Accordingly, charging/discharging is performed in the second charging/discharging unit 406B so that a charge amount in a capacitance relative to a ground of the photovoltaic string 103 is the same as a capacitance relative to a ground charge amount when the photovoltaic string is connected to the second measurement unit 303B. The second charging/discharging unit 406B includes a second resistor 461B having one side connected to the ground potential G. A resistance value of the second resistor 461B is the same as a resistance value of the second resistor 331B of the second measurement unit 303B.

Further, the calculation control unit 4 further has a charging/discharging function for instructing the first and second charging/discharging switches 423 and 424 of the switching unit 402 to perform ON/OFF switching to thereby instruct the photovoltaic string 103 in the disconnected state to perform charging/discharging.

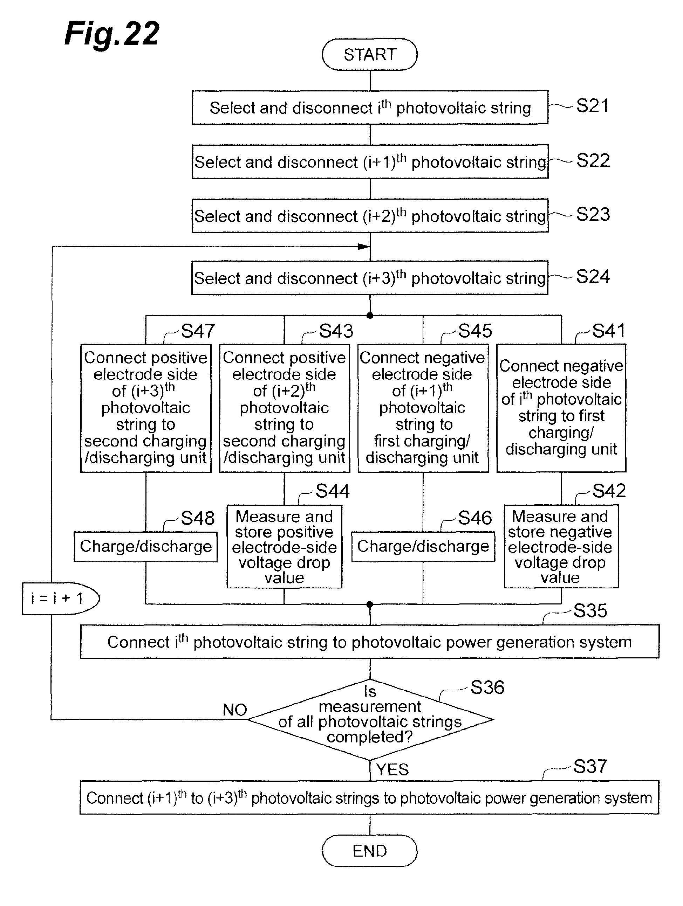

Next, an example of a ground fault detection method (operation of the ground fault detection program) performed by the ground fault detection device 401 will be illustrated and described with reference to a flowchart illustrated in Fig. 22.

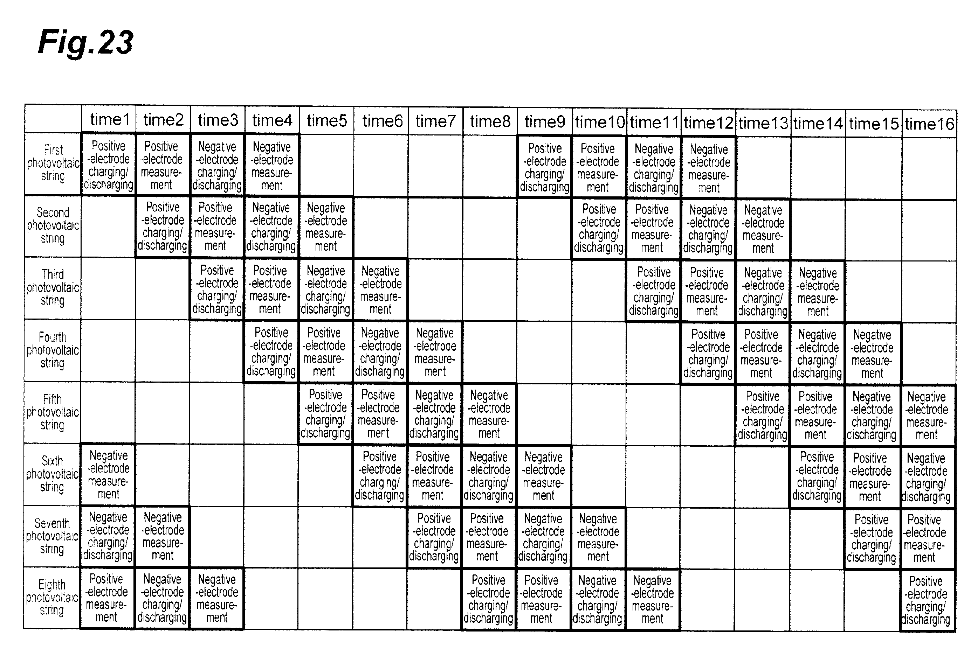

In such an embodiment, when a ground fault within the photovoltaic array 101 is detected, the four photovoltaic strings 103 among the plurality of photovoltaic strings 103 are sequentially disconnected from the photovoltaic power generation system 400, as illustrated in the operation scheme of Fig. 23 (a bold frame in Fig. 23). In this case, the first measurement unit 303A is connected to the photovoltaic string 103 in the disconnected state to measure the negative electrode-side voltage drop value $V_3$, and in parallel therewith, the second measurement unit 303B is connected to the separate photovoltaic string 103 in the disconnected state to measure the positive electrode-side voltage drop value $V_4$. Herewith, the first charging/discharging unit 406A is connected to the photovoltaic string 103 which is in the disconnected state and has not yet been subjected to the measurement of the first measurement unit 303A to charge/discharge the photovoltaic string, and in parallel therewith, the second charging/discharging unit 306B is connected to the photovoltaic string 103 which is in a disconnected state and has not yet been subjected to the measurement of the second measurement unit 303B to charge/discharge the photovoltaic string.

Further, a photovoltaic array 101 including eight photovoltaic strings 103 is illustrated in Fig. 23. Further, states of the ground fault detection device 401 illustrated in Figs. 18 to 21 correspond to states when TIME=1 to 4 in Fig. 23, respectively.

Specifically, when i is an integer equal to or more than 1, i=i-n when i>n, and an initial value of i is n-2, the measurement switch element 308a of the $i^{th}$ photovoltaic string $103_{n-2}$ in the disconnected state is turned on to connect the photovoltaic string to the first measurement unit 303A after the $(i+3)^{th}$ photovoltaic string $103_1$ is selected to disconnect the photovoltaic string from the photovoltaic power generation system 400 (after S24 described above), as illustrated in the flowchart of Fig. 22 (S41). Accordingly, the photovoltaic string $103_{n-2}$ enters the first potential state. In this state, the negative electrode-side voltage drop value $V_3$ and its sign of the $i^{th}$ photovoltaic string $103_{n-2}$ are measured by the first voltmeter 332A, and a result of the measurement is stored in the storage unit 5 (S42).

In parallel with the process of S41 and S42 described above, the measurement switch element 309a of the $(i+2)^{th}$ photovoltaic string $103_n$ in the disconnected state is turned on to connect the photovoltaic string to the second measurement unit 303B (S43). Accordingly, the photovoltaic string $103_n$ enters the second potential state. In this state, the positive electrode-side voltage drop value $V_4$ and its sign of the $(i+2)^{th}$ photovoltaic string $103_n$ are measured by the second voltmeter 332B, and a result of the measurement is stored in the storage unit 5 (S44).

In parallel with the process of S41 to S44 described above, the charging/discharging switch element 423a of the $(i+1)^{th}$ photovoltaic string $103_{n-1}$ in the disconnected state is turned on to connect the photovoltaic string to the first charging/discharging unit 406A, causing the photovoltaic string $103_{n-1}$ to enter the first potential state (S45). Accordingly, charging/discharging is performed by the first charging/discharging unit 406A until an amount of charges stored in a capacitance relative to a ground of the $(i+1)^{th}$ photovoltaic string $103_{n-1}$ is the same as an amount of charges stored in a capacitance relative to a ground when the negative electrode side is connected to the first measurement unit 303A (S46).

In parallel with the process of S41 to S46 described above, the charging/discharging switch element 424a of the $(i+3)^{th}$ photovoltaic string $103_1$ in the disconnected state is turned on to connect the photovoltaic string to the second charging/discharging unit 406B, causing the photovoltaic string 1031 to enter the second potential state (S47). Accordingly, charging/discharging is performed by the second charging/discharging unit 406B until an amount of charges stored in a capacitance relative to a ground of the $(i+3)^{th}$ photovoltaic string $103_1$ is the same as an amount of charges stored in a capacitance relative to a ground when the positive electrode side is connected to the second measurement unit 303B (S48).

Also, the process proceeds to S3 5 above to turn on the disconnection switch elements 7a and 7a for the $i^{th}$ photovoltaic string $103_{n-2}$ in the disconnected state to connect the photovoltaic string to the photovoltaic power generation system 400. Further, when the voltage drop values $V_3$ and $V_4$ are stored in the storage unit 5 for each photovoltaic string 103, it can be determined whether there is a ground fault of the photovoltaic string 103 in this embodiment as well, as in the procedure illustrated in the flowchart of Fig. 7.

As described above, in this embodiment, the one and other photovoltaic strings 103 and 103 for which the voltage drop values $V_3$ and $V_4$ are to be measured can be disconnected from the photovoltaic power generation system 400. Further, it is possible to achieve efficiency of the ground fault detection since the separate measurements can be performed on the one and other photovoltaic strings 103 and 103 in the disconnected state. Thus, the action effects described above, i.e., action effects of reliably detecting the ground fault and shortening a time required for detection of the ground fault, are achieved.

Further, in this embodiment, the photovoltaic strings 103 and 103 before the voltage drop values $V_3$ and $V_4$ are measured can be charged/discharged in advance, in parallel with measuring the voltage drop values $V_3$ and $V_4$ for

the photovoltaic strings 103 and 103 in the disconnected state, as described above. Thus, variation of the measured voltage drop values $V_3$ and $V_4$ can be suppressed and such measurement can be performed without waiting immediately after the first and the second measurement units 303A and 303B are connected to the photovoltaic string 103. Therefore, it is possible to further shorten a time required for detection of the ground fault in the photovoltaic array 101.

[Fifth embodiment]

Next, a fifth embodiment of the present invention will be described. Further, differences between the fifth embodiment and the first embodiment will be mainly described in the fifth embodiment.

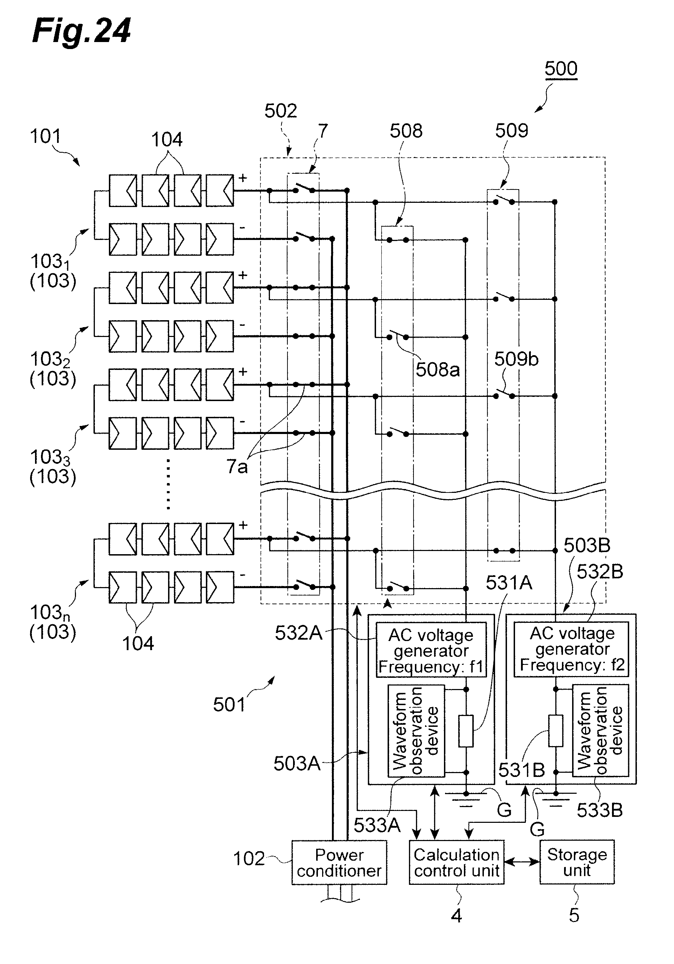

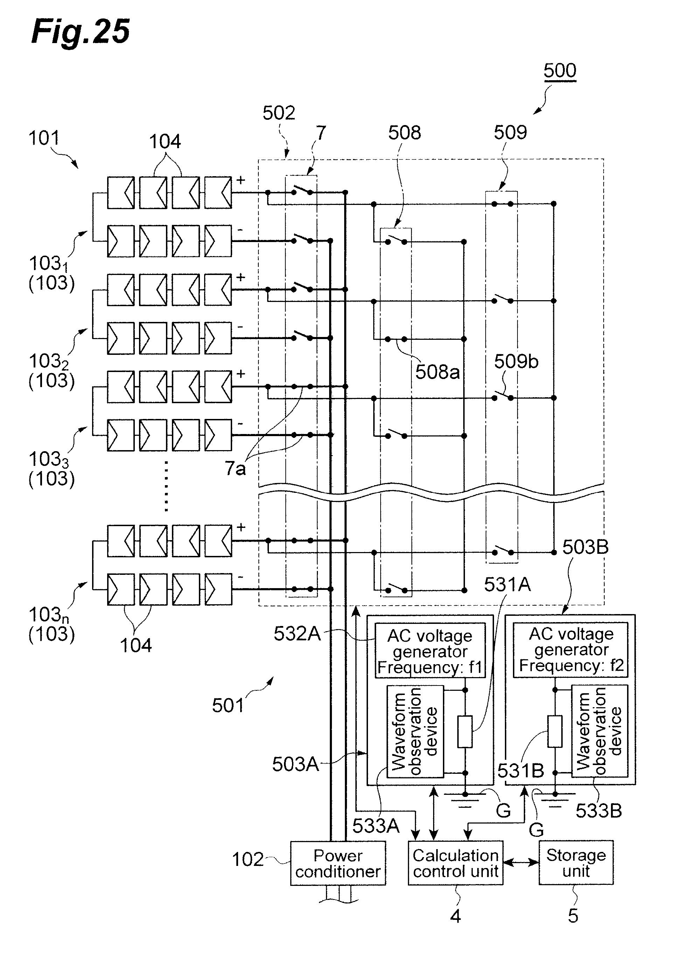

Figs. 24 and 25 are schematic configuration diagrams illustrating a photovoltaic power generation system including a ground fault detection device according to a fifth embodiment. The ground fault detection device 501 of this embodiment includes a switching unit 502 in place of the switching unit 2 (see Fig. 1), and includes first and second measurement units 503A and 503B in place of the first and second measurement units 3A and 3B (see Fig. 1), as illustrated in Figs. 24 and 25.

The switching unit 302 includes a first measurement switch 508 in place of the first measurement switch 8, and includes a second measurement switch 509 in place of the second measurement switch 9. The first measurement switch 508 is located between the photovoltaic string 103 and the first measurement unit 503A, switches electrical connection/non-connection therebetween, and includes a measurement switch element 308a connected to the positive electrode side of each photovoltaic string 103.

The second measurement switch 509 is located between the photovoltaic string 103 and the second measurement unit 503B, switches electrical connection/non-connection therebetween, and includes a measurement switch element 509a connected to the positive electrode side of each photovoltaic string 103.

The first measurement unit 503A includes a first alternating current power supply 532A having one side connected to the ground potential G through a first resistor 531A, and a waveform observation device 533A which measures a first leakage current value $I_1$ flowing between the first alternating current power supply 532A and the ground potential G and its waveform.

The first alternating current power supply 532A applies an alternating current voltage (AC bias) having a first alternating current voltage value $Va_1$ at a first frequency f1 to the photovoltaic string 103. Accordingly, the photovoltaic string 103 enters a first potential state.

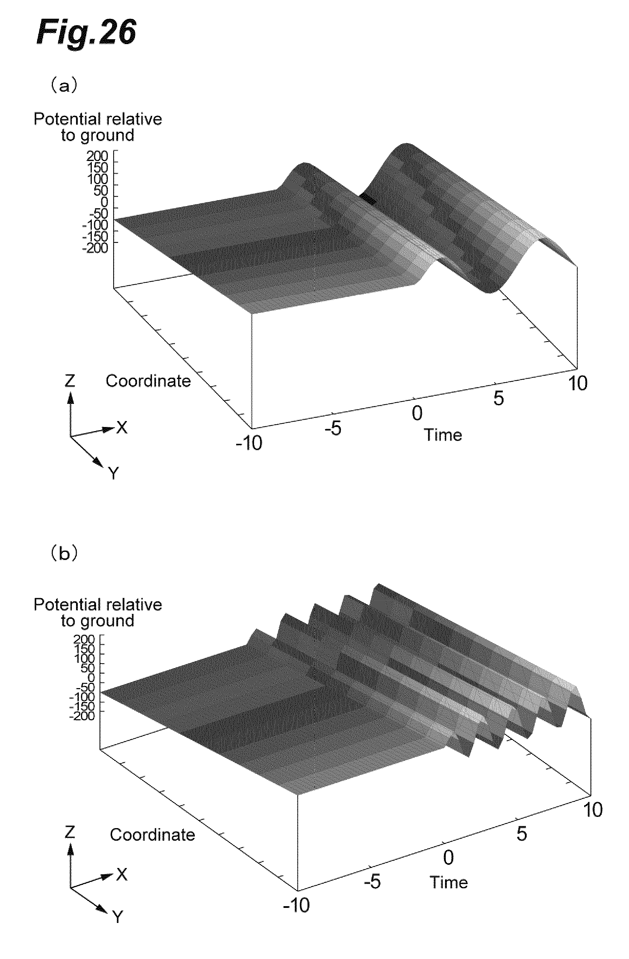

A first potential state of this embodiment is a state in which the potential relative to the ground of each coordinate of the photovoltaic string 103 is in a state illustrated in Fig. 26(a) due to application of an alternating current voltage at a first frequency f1. In other words, for example, when the alternating current voltage having the first frequency f1 which is a low frequency at an amplitude of 100 V is applied to a middle point of the photovoltaic string 103 of a voltage value of 200 V at a time point of time=0, the potential relative to the ground of each coordinate begins to vibrate, and then steadily vibrates at an amplitude of 100 V and a low frequency.

The other side of the first alternating current power supply 532A is electrically connected to the positive electrode bus of the photovoltaic string 103 through the first measurement switch 508. Further, voltage amplitude of the first alternating current voltage value $Va_1$ is equal to or more than a predetermined lower limit value from the viewpoint of improving sensitivity of the ground fault detection and is equal to or less than a predetermined upper limit value from the viewpoint of preventing damage of an electrical circuit. Further, the first alternating current voltage value $Va_1$ herein is the same voltage value as the voltage value of one photovoltaic string 103 as a preferable value.

The first alternating current power supply 532A is connected to the calculation control unit 4, and applies the alternating current voltage value $Va_1$ according to an instruction signal from the calculation control unit 4. Further, the first alternating current power supply 532A stores a waveform of the alternating current voltage value $Va_1$ in the storage unit 5. The first resistor 531A has a resistance value which is a resistance value Rd. The waveform observation device 533A is electrically connected between the switching unit 502 and the first resistor 531A and between the first resistor 531A and the ground potential G, and measures a first leakage current value $I_1$ flowing between the first alternating current power supply 532A and the ground potential G and its waveform.

The second measurement unit 503A includes a second alternating current power supply 532B having one side connected to the ground potential G through the second resistor 531A, and a waveform observation device 533B which measures a second leakage current value $I_2$ flowing between the second alternating current power supply 532B and the ground potential G and its waveform.

The second alternating current power supply 532B applies an alternating current voltage (AC bias) having a second alternating current voltage value $Va_2$ at a second frequency f2 to the photovoltaic string 103. Accordingly, the photovoltaic string 103 enters a first potential state.

The second potential state of this embodiment is a potential state different from the first potential state. The second potential state herein is a state in which the potential relative to the ground of each coordinate of the photovoltaic string 103 becomes a state illustrated in Fig. 26(b) from application of an alternating current voltage having a second frequency f2. In other words, for example, when the alternating current voltage having a second frequency f1 which is a high frequency at an amplitude of 100 V is applied to a middle point of the photovoltaic string 103 of a voltage value of 200 V at a time point of time=0, the potential relative to the ground of each coordinate begins to vibrate, and then steadily vibrates at an amplitude of 100 V and a high frequency.

The other side of the second alternating current power supply 532B is electrically connected to the positive electrode bus of the photovoltaic string 103 through the second measurement switch 509. Further, voltage amplitude of the second alternating current voltage value $Va_2$ has the same value as the voltage amplitude of the first alternating current voltage value $Va_1$.

The second alternating current power supply 532B is connected to the calculation control unit 4, and applies the second alternating current voltage value $Va_2$ according to an instruction signal from the calculation control unit 4. Further, the second alternating current power supply 532B stores a waveform of the second alternating current voltage value $Va_2$ in the storage unit 5. The second resistor 531B has a resistance value which is the same resistance value Rd as the first resistor 531A. The waveform observation device 533B is electrically connected between the switching unit 502 and the second resistor 531B and between the second resistor 531B and the ground potential G, and measures the second leakage current value $I_2$ flowing between the second alternating current power supply 532B and the ground potential G and its waveform.

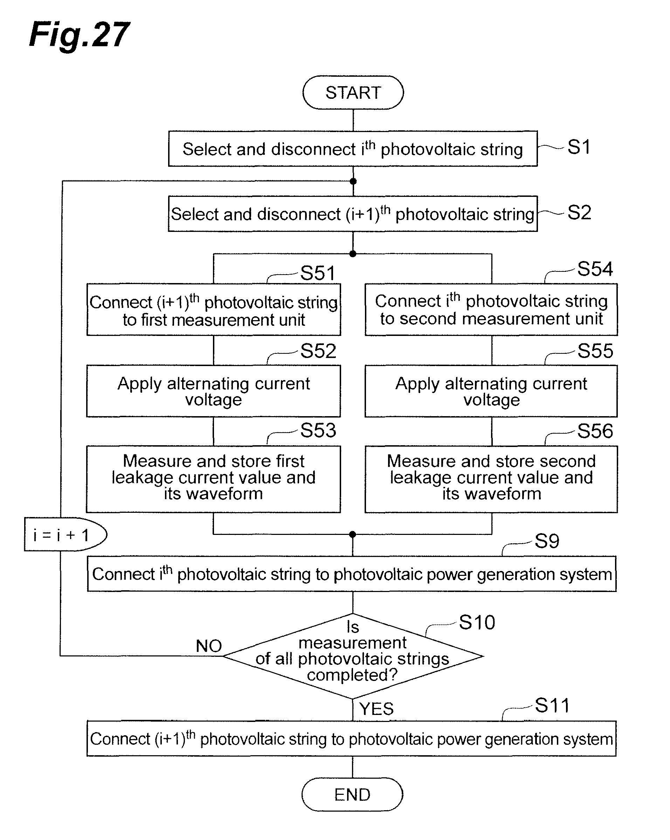

Next, an example of a ground fault detection method (operation of a ground fault detection program) performed by the ground fault detection device 501 will be illustrated and described with reference to a flowchart illustrated in Fig. 27.

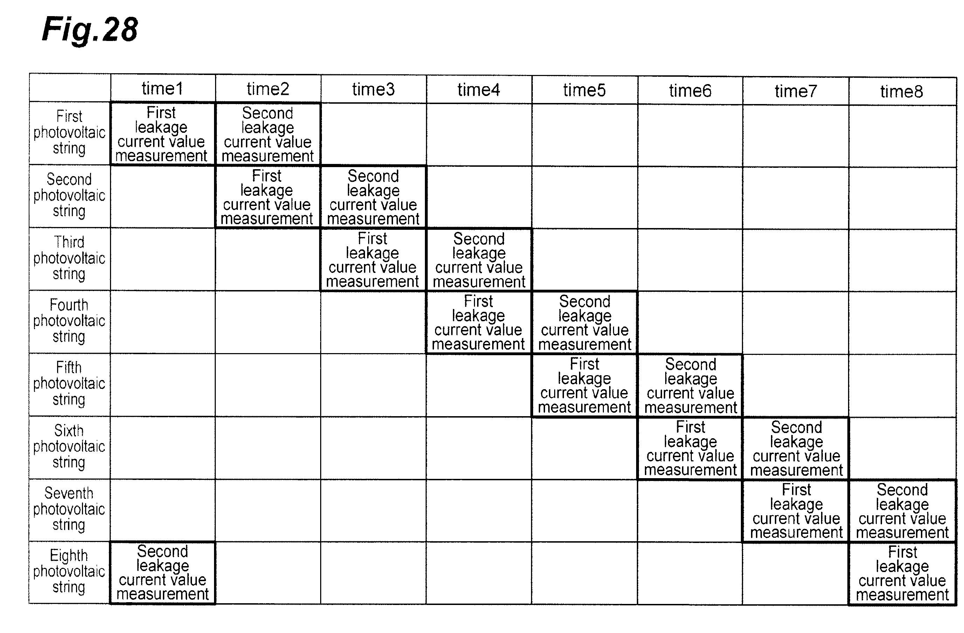

In such an embodiment, when a ground fault within the photovoltaic array 101 is detected, two photovoltaic strings 103 among the plurality of photovoltaic strings 103 are sequentially disconnected from the photovoltaic power generation system 500, for example, as illustrated in an operation scheme of Fig. 28 (a bold frame in Fig. 28). In this case, the first measurement unit 503A is connected to the one photovoltaic string 103 in the disconnected state to measure a first leakage current value $I_1$ and its waveform, and in parallel therewith, the second measurement unit 503B is connected to the other photovoltaic string 103 in the disconnected state to measure a second leakage current value $I_2$ and its waveform.

Further, a photovoltaic array 101 including eight photovoltaic strings 103 is illustrated in Fig. 28. Further, states of the ground fault detection device 501 illustrated in Figs. 24 and 25 correspond to states when TIME=1 and 2 in Fig. 28, respectively.

Specifically, when i is an integer equal to or more than 1, i=i-n when i>n, and an initial value of i is n, the measurement switch element 508a is turned on for the other $(i+1)^{th}$ photovoltaic string $103_1$ in the disconnected state to connect the photovoltaic string to the first measurement unit 503A after the $(i+1)^{th}$ photovoltaic string $103_1$ is selected and disconnected from the photovoltaic power generation system 500 (after S2 described above), as illustrated in the flowchart of Fig. 27 (S51). Also, a first alternating current voltage value $Va_1$ at a first frequency f1 is applied to the photovoltaic string $103_1$ by the first alternating current power supply 532A (S52). Accordingly, the photovoltaic string $103_1$ enters the first potential state. In this state, a first leakage current value $I_1$ and its waveform of the $(i+1)^{th}$ photovoltaic string $103_1$ are measured by the waveform observation device 533A, and a result of the measurement is stored in the storage unit 5 (S53).

In parallel with the process of S51 to S53 described above, the measurement switch element 509a is turned on for the one $i^{th}$ photovoltaic string $103_n$ among the photovoltaic strings $103_n$ and $103_1$ in the disconnected state to connect the photovoltaic string to the second measurement unit 503B (S54). Also, a second alternating current voltage value $Va_2$ at a second frequency f2 is applied to the photovoltaic string $103_n$ by the second alternating current power supply 532B (S55). Accordingly, the photovoltaic string $103_n$ enters the second potential state. In this state, a second leakage current value $I_2$ and its waveform of the $i^{th}$ photovoltaic string $103_n$ are measured by the waveform observation device 533B, and a result of the measurement is stored in the storage unit 5 (S56). Also, the process then proceeds to S10 described above to perform a determination as to whether or not the measurements of the leakage current values $I_1$ and $I_2$ (S51 to S56 described above) are completed for all the photovoltaic strings 103.

Further, when the leakage current values $I_1$ and $I_2$ and their waveforms are stored for each photovoltaic string 103 in the storage unit 5, it is determined whether there is a ground fault of the photovoltaic string 103 as shown below, as in the procedure of the flowchart of Fig. 7.

Specifically, the following process is first performed as S12 described above. In other words, the first leakage current value $I_1$ is divided into a leakage current value $I_{1-R}$ which is a component in phase with the first alternating current voltage value $Va_1$ and a leakage current value $I_{1-C}$ which is a component 90 degrees out of phase with the first alternating current voltage value $Va_1$. Further, the second leakage current value $I_2$ is divided into a leakage current value $I_{2-R}$ which is a component in phase with the second alternating current voltage value $Va_2$ and a leakage current value $I_{2-C}$ which is a component 90 degrees out of phase with the second alternating current voltage value $Va_2$.

Subsequently, the respective leakage current values $I_{1-R}$ and $I_{2-R}$ are plotted for the first and second frequencies f1 and f2 of the respective alternating current power supplies 532A and 532B. Also, an insulation resistance value $R_{leak}$ is obtained by obtaining the leakage current value at f=0 through extrapolation as a current value $I_{3-R0}$ and dividing the first alternating current voltage value $Va_1$ (or the second alternating current voltage value $Va_2$) by this leakage current value $I_{3-R0}$. Also, the process then proceeds to S13 described above to perform the ground fault determination of the photovoltaic array 101.

As described above, in this embodiment, the one and other photovoltaic strings 103 and 103 for which the leakage current values $I_1$ and $I_2$ are to be measured can be disconnected from the photovoltaic power generation system 500. Further, since separate measurements can be performed in parallel on the one and other photovoltaic strings 103 and 103 in the disconnected state, it is possible to achieve efficiency of the ground fault detection. Thus, the action effects described above, i.e., action effects of reliably detecting the ground fault and shortening a time required for detection of the ground fault, are achieved.

Further, in this embodiment, it is possible to suitably detect the ground fault of the photovoltaic string 103 by monitoring the current value $I_{1-R}$ in phase with the first alternating current voltage value $Va_1$ in the first leakage current value $I_1$ and the current value $I_{2-R}$ in phase with the second alternating current voltage value $Va_2$ in the second leakage current value $I_2$.

While the preferred embodiments of the present invention have been described above, the present invention is not limited to the embodiments and may be changed or applied to other things without departing from the gist defined in each claim.

For example, in the embodiment, while the power conditioner 102 is included as a load device, the load device may be a direct current load such as a converter or a storage battery as long as it consumes or converts power. Further, the number of photovoltaic modules 104 constituting each photovoltaic string 103 may be 2 to 7 or may be 9 or more.

Further, the number of disconnected photovoltaic string 103 disconnected from the photovoltaic power generation system at the same time may be 3 or 5. Further, the number of photovoltaic strings 103 to be measured by the first measurement unit and the number of photovoltaic strings 103 to be measured by the second measurement unit may be 2 or more.

Further, in the above embodiment, while the configurations in which measurement is performed using the temporally stabilized (converged) states as the first and second potential states (see Figs. 3 and 4 and Figs. 16(a) and (b)) or temporally vibrating states in a certain period of time (see Figs. 26(a) and (b)) have been described by way of example, the present invention is not limited thereto.

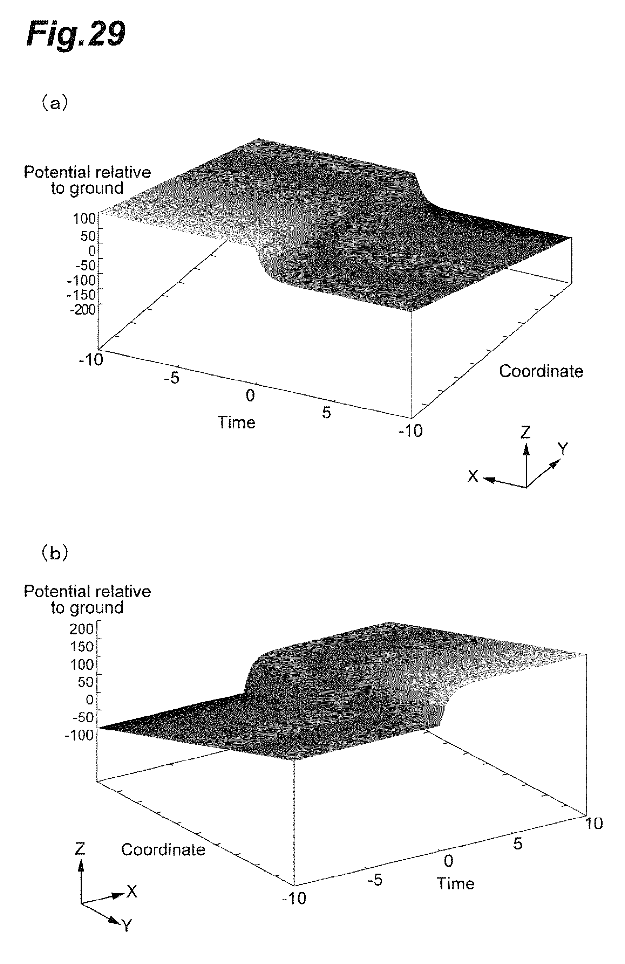

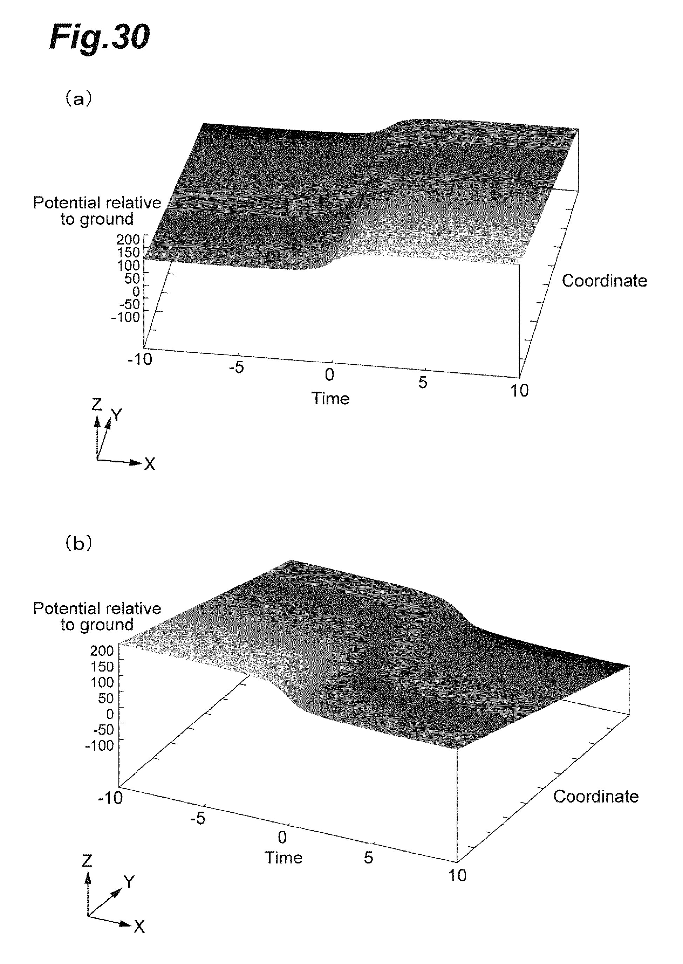

For example, a configuration in which a process including a process in which the potential relative to the ground of the photovoltaic string 103 is steeply changed from one stable state to another stable state, is regarded as one potential state, and measurement is performed using the two potential states, as illustrated in Figs. 29(a) and (b), may be adopted. Or, a configuration in which a process including a process in which the potential relative to the ground of the photovoltaic string 103 is gently changed from one stable state to another stable state and is regarded as one potential state, and measurement is performed using the two potential states, as illustrated in Figs. 30(a) and (b), may be adopted.

Further, in the above embodiment, a plurality of photovoltaic strings 103 may constitute a photovoltaic string group, and a plurality of photovoltaic string groups may constitute the photovoltaic array 101. In this case, two or more photovoltaic string groups among the plurality of photovoltaic string groups are disconnected from the photovoltaic power generation system, the measurement of the first measurement unit is performed on the one photovoltaic string group in the disconnected state, and in parallel therewith, the measurement of the second measurement unit is performed on the other photovoltaic string groups in the disconnected state.

Incidentally, "the same" described above includes substantially the same and allows a variation or an error on manufacture, design or measurement. Further, the first and second potential states are not limited to those described above, and may be various potential states. The calculation control unit 4, the first measurement switches 8, 308 and 508, and the second measurement switches 9, 309 and 509 above constitute a control unit. Further, the calculation control unit 4 constitutes a determination unit.

Here, in this embodiment, it is desirable for the switching unit to disconnect as many photovoltaic strings as a sum of the number of one photovoltaic string to be measured by the first measurement unit and the number of other photovoltaic strings to be measured by the second measurement unit from the photovoltaic power generation system. In this case, since only necessary photovoltaic strings can be disconnected, it is possible to reduce unnecessary disconnection of the photovoltaic strings.

Further, it is desirable for the switching unit to electrically connect to the photovoltaic power generation system when no ground fault is determined for the disconnected photovoltaic string by the determination unit, and to keep a state in which the photovoltaic string is disconnected from the photovoltaic power generation system when it is determined that there is a ground fault by the determination unit. In this case, it is possible to cause the photovoltaic string having no ground fault to contribute to power generation.

Further, it is desirable for the determination unit to calculate the insulation resistance value based on the first and second measurement values and determine that there is a ground fault when the insulation resistance value is equal to or smaller than the predetermined value or is smaller than the predetermined value. In this case, since the insulation resistance value does not depend on the potential relative to the ground of the photovoltaic string, it is possible to suitably perform a determination of whether there is a ground fault.

Further, it is preferable for the first measurement unit to measure the first measurement value by causing a potential relative to a ground of the one photovoltaic string to enter a first potential state when the first measurement unit is connected to the one photovoltaic string disconnected by the switching unit, and for the second measurement unit to measure the second measurement value by causing a potential relative to a ground of the other photovoltaic string to enter a second potential state different from the first potential state when the second measurement unit is connected to the other photovoltaic string disconnected by the switching unit. In this case, when the ground fault is detected from two types of potential states (i.e., the first and second potential states), it is possible to shorten the time required for detection of the ground fault.

Further, it is preferable for the first measurement unit to at least include a first electrical path having one side connected to the ground potential and the other side connectable to the photovoltaic string, and a direct current power supply provided on the first electrical path, and to measure a measurement value for a value of a current flowing in the first electrical path as the first measurement value by causing the one photovoltaic string to enter the first potential state by connecting the other side of the first electrical path to the one photovoltaic string disconnected by the switching unit, and for the second measurement unit to at least include a second electrical path having one side connected to the ground potential and the other side connectable to the photovoltaic string, and to measure a measurement value for a value of a current flowing in the second electrical path as the second measurement value by causing the other photovoltaic string to enter the second potential state by connecting the other side of the second electrical path to the other photovoltaic string disconnected by the switching unit.

In this case, it is possible to suitably detect the ground fault of the photovoltaic string by monitoring the first and second measurement values for the current values flowing through the first and second electrical circuits. Further, "the measurement value for the current value" corresponds to, for example, a current value when a value of a current flowing between the circuit and the ground potential is directly monitored using a current sensor or the like, and corresponds to a voltage value (or a voltage drop value) when a voltage value of a predetermined point (or a voltage drop value in a predetermined section) on the first and second electrical paths is monitored using a voltmeter or the like (the same applies hereinafter). Further, when the voltage value is monitored, for example, the first resistor may be provided on the first electrical path, the second resistor may be provided on the second electrical path, the first voltage drop value generated in the first resistor may be measured as the first measurement value, and the second voltage drop value generated in the second resistor may be measured as the second measurement value.

Further, it is preferable for the first measurement unit to include a first resistor having one side connected to the ground potential, and to measure a measurement value for a value of a current flowing in the first resistor as the first measurement value by causing the one photovoltaic string to enter the first potential state by connecting the other side of the first resistor to only the positive electrode side of the one photovoltaic string disconnected by the switching unit, and for the second measurement unit to include a second resistor having one side connected to the ground potential, and to measure a measurement value for a value of a current flowing in the second resistor as the second measurement value by causing the other photovoltaic string to enter the second potential state by connecting the other side of the second resistor to only the negative electrode side of the other photovoltaic string disconnected by the switching unit. In this case, it is possible to suitably detect a ground fault within the photovoltaic array by monitoring the first and second measurement values for the values of currents flowing through the first and second resistances.

Further, it is preferable for the first measurement unit to at least include a first alternating current power supply having one side connected to the ground potential and having a first alternating current voltage value at a first frequency, and to measure, as the first measurement value, a measurement value for the current value in phase with the first alternating current voltage value among values of currents flowing between the first alternating current power supply and the ground potential by causing the one photovoltaic string to enter the first potential state by connecting the other side of the first alternating current power supply to the one photovoltaic string disconnected by the switching unit, and for the second measurement unit to at least include a second alternating current power supply having one side connected to a ground potential and having a second alternating current voltage value at a second frequency different from the first frequency, and to measure, as the second measurement value, a measurement value for the current value in phase with the second alternating current voltage value among values of currents flowing between the second alternating current power supply and the ground potential by causing the other photovoltaic string to enter the second potential state by connecting the other side of the second alternating current power supply to the other photovoltaic string disconnected by the switching unit.

In this case, it is possible to suitably detect the ground fault of the photovoltaic string by monitoring a measurement value for a current value in phase with a first frequency among current values flowing between the first alternating current power supply and the ground potential, and a measurement value for a current value in phase with a second frequency among current values flowing between the second alternating current power supply and the ground potential. Further, "the measurement value for the current value" corresponds to, for example, a current value when a value of a current flowing between the power supply and the ground potential is directly monitored using a current sensor or the like, and corresponds to a voltage value when a resistor is provided and a voltage value generated in this resistor is monitored using a voltmeter or the like (the same applies hereinafter).

Industrial **Applicability**

The present invention may be applied to a ground fault detection device, a ground fault detection method, a photovoltaic power generation system, and a ground fault detection program, and is capable of reliably detecting the ground fault and shortening the time required for detection of the ground fault.

**Reference Signs List**

1, 201, 301, 401, 501 ... ground fault detection device, 3A, 303A, 503A ... first measurement unit, 3A, 303A, 503A ... second measurement unit, 4 ... calculation control unit (determination unit or control unit), 7 ... disconnection switch (switching unit), 8, 308, 508 ... first measurement switch (control unit), 9, 309, 509 ... second measurement switch (control unit), 31 A ... first resistor, 31B ... second resistor, 32A ... direct current power supply, 100, 200, 300, 400, 500 ... photovoltaic power generation system, 101 ... photovoltaic array, 102 ... power conditioner (load device), 103 ... photovoltaic string, 104 ... photovoltaic module, 331A ... first resistor, 331B second resistor, 532A ... first alternating current power supply, 532B ... second alternating current power supply, G ... ground potential, $I_{1\text{-}R}$ ... leakage current value (first measurement value), $I_{2\text{-}R}$ ... leakage current value (second measurement value), O1 ... first connection portion, 02 ... second connection portion, $V_1$ ... voltage value (first measurement value), $V_2$ ... voltage value (second measurement value), $V_3$ ... negative electrode-side voltage drop value (second measurement value), $V_4$ ... positive electrode voltage drop value (first measurement value), $Va_1$ ... first alternating current voltage value, $Va_2$ ... second alternating current voltage value.

**Claims**

1. A ground fault detection device which detects a ground fault within a photovoltaic array in a photovoltaic power generation system comprising

   photovoltaic strings configured in such a manner that a plurality of photovoltaic modules are connected in series; the photovoltaic array configured in such a manner that the plurality of photovoltaic strings are connected in parallel; and

   a load device which consumes or converts power,

   wherein the ground fault detection device includes

   a switching unit which disconnects two or more photovoltaic strings among the plurality of photovoltaic strings from the photovoltaic power generation system electrically separating the photovoltaic strings from each other;

   a first measurement unit which measures a first measurement value for ground fault detection for each of the plurality of photovoltaic strings;

   a second measurement unit which performs a measurement separate from the measurement of the first measurement unit for each of the plurality of photovoltaic strings to measure a second measurement value for ground fault detection;

   a determination unit which determines whether there is a ground fault based on the first and second measurement values measured by the first and second measurement units for each of the plurality of photovoltaic strings; and

   a control unit which at least controls operations of the first and second measurement units, and

   the control unit

   connects the first measurement unit to one photovoltaic string among the two or more photovoltaic strings disconnected by the switching unit and causes the first measurement unit to measure the first measurement value of the one photovoltaic string, and in parallel therewith,

   connects the second measurement unit to the other photovoltaic string among the two or more photovoltaic strings disconnected by the switching unit and causes the second measurement unit to measure the second measurement value of the other photovoltaic string.

2. The ground fault detection device according to claim 1, wherein:

   the switching unit disconnects, from the photovoltaic power generation system, as many photovoltaic strings as a sum of the number of one photovoltaic string to be measured by the first measurement unit and the number of other photovoltaic strings to be measured by the second the measurement unit.

3. The ground fault detection device according to claim 1 or 2, wherein:

the switching unit electrically connects the disconnected photovoltaic string to the photovoltaic power generation system when no ground fault is determined for the disconnected photovoltaic string by the determination unit, and keeps a state in which the disconnected photovoltaic string is disconnected from the photovoltaic power generation system when it is determined that there is a ground fault by the determination unit.

4.  The ground fault detection device according to any one of claims 1 to 3, wherein:

the determination unit calculates an insulation resistance value based on the first and second measurement values, and determines that there is a ground fault when the insulation resistance value is equal to or smaller than a predetermined value or is smaller than the predetermined value.

5.  The ground fault detection device according to any one of claims 1 to 4, wherein:

the first measurement unit measures the first measurement value by causing a potential relative to a ground of the one photovoltaic string to enter a first potential state when the first measurement unit is connected to the one photovoltaic string disconnected by the switching unit, and
the second measurement unit measures the second measurement value by causing a potential relative to a ground of the other photovoltaic string to enter a second potential state different from the first potential state when the second measurement unit is connected to the other photovoltaic string disconnected by the switching unit.

6.  The ground fault detection device according to claim 5, wherein:

the first measurement unit
at least includes a first electrical path having one side connected to the ground potential and the other side connectable to the photovoltaic string, and a direct current power supply provided on the first electrical path, and measures a measurement value for a value of a current flowing in the first electrical path as the first measurement value by causing the one photovoltaic string to enter the first potential state by connecting the other side of the first electrical path to the one photovoltaic string disconnected by the switching unit, and
the second measurement unit
at least includes a second electrical path having one side connected to the ground potential and the other side connectable to the photovoltaic string, and
measures a measurement value for a value of a current flowing in the second electrical path as the second measurement value by causing the other photovoltaic string to enter the second potential state by connecting the other side of the second electrical path to the other photovoltaic string disconnected by the switching unit.

7.  The ground fault detection device according to claim 5, wherein:

the first measurement unit
includes a first resistor having one side connected to the ground potential, and
measures a measurement value for a value of a current flowing in the first resistor as the first measurement value by causing the one photovoltaic string to enter the first potential state by connecting the other side of the first resistor to only the positive electrode side of the one photovoltaic string disconnected by the switching unit, and
the second measurement unit
includes a second resistor having one side connected to the ground potential, and
measures a measurement value for a value of a current flowing in the second resistor as the second measurement value by causing the other photovoltaic string to enter the second potential state by connecting the other side of the second resistor to only the negative electrode side of the other photovoltaic string disconnected by the switching unit.

8.  The ground fault detection device according to claim 5, wherein:

the first measurement unit
at least includes a first alternating current power supply having one side connected to the ground potential and having a first alternating current voltage value at a first frequency, and
measures, as the first measurement value, a measurement value for the current value in phase with the first alternating current voltage value among values of currents flowing between the first alternating current power supply and the ground potential by causing the one photovoltaic string to enter the first potential state by connecting the other side of the first alternating current power supply to the one photovoltaic string disconnected by the switching unit, and

the second measurement unit

at least includes a second alternating current power supply having one side connected to an ground potential and having a second alternating current voltage value at a second frequency different from the first frequency, and measures, as the second measurement value, a measurement value for the current value in phase with the second alternating current voltage value among values of currents flowing between the second alternating current power supply and the ground potential by causing the other photovoltaic string to enter the second potential state by connecting the other side of the second alternating current power supply to the other photovoltaic string disconnected by the switching unit.

9.  A ground fault detection method for detecting a ground fault within a photovoltaic array in a photovoltaic power generation system comprising:

photovoltaic strings configured in such a manner that a plurality of photovoltaic modules are connected in series;
the photovoltaic array configured in such a manner that the plurality of photovoltaic strings are connected in parallel; and
a load device which consumes or converts power,
wherein the ground fault detection method includes:

a disconnection step of disconnecting two or more photovoltaic strings among the plurality of photovoltaic strings from the photovoltaic power generation system electrically separating the photovoltaic strings from each other;
a first measurement step of measuring a first measurement value for ground fault detection for each of the plurality of photovoltaic strings;
a second measurement step of performing a measurement separate from the measurement of the first measurement step for each of the plurality of photovoltaic strings to measure a second measurement value for ground fault detection; and
a determination step of determining whether there is a ground fault based on the first and second measurement values measured in the first and second measurement steps for each of the plurality of photovoltaic strings,
the first measurement step includes measuring the first measurement value in one photovoltaic string among the two or more photovoltaic strings disconnected in the disconnection step, and
the second measurement step includes measuring the second measurement value in the other photovoltaic string among the two or more photovoltaic strings disconnected in the disconnection step, in parallel with measuring the first measurement value in the first measurement step.

10. A photovoltaic power generation system comprising:

photovoltaic strings configured in such a manner that a plurality of photovoltaic modules are connected in series;
a photovoltaic array configured in such a manner that the plurality of photovoltaic strings are connected in parallel;
a load device which consumes or converts power; and
a ground fault detection device according to any one of claims 1 to 8.

11. A ground fault detection program for detecting a ground fault within a photovoltaic array in a photovoltaic power generation system comprising:

photovoltaic strings configured in such a manner that a plurality of photovoltaic modules are connected in series;
the photovoltaic array configured in such a manner that the plurality of photovoltaic strings are connected in parallel; and
a load device which consumes or converts power,
wherein the ground fault detection program causes a computer to execute:

a disconnection function for disconnecting two or more photovoltaic strings among the plurality of photovoltaic strings from the photovoltaic power generation system electrically separating the photovoltaic strings from each other;
a first measurement function for measuring a first measurement value for ground fault detection for each of the plurality of photovoltaic strings;

a second measurement function for performing a measurement separate from the measurement by the first measurement function for each of the plurality of photovoltaic strings to measure a second measurement value for ground fault detection; and

a determination function for determining whether there is a ground fault based on the first and second measurement values measured through the first and second measurement functions for each of the plurality of photovoltaic strings,

the first measurement function includes measuring the first measurement value in the photovoltaic string among the two or more photovoltaic strings disconnected through the disconnection function, and

the second measurement function includes measuring the second measurement value in the other photovoltaic string among the two or more photovoltaic strings disconnected in the disconnection function, in parallel with measuring the first measurement value through the first measurement function.

# Fig.1

# Fig.2

# Fig.3

# *Fig.4*

# Fig.5

Switching unit                    4

Photovoltaic string selection function

Disconnection control function

First measurement function

Second measurement function

First measurement unit

Second measurement unit

Storage function

Calculation function

Ground fault determination function

Storage unit

## Fig.6

```
                          ┌─────────┐
                          │  START  │
                          └─────────┘
                               │
        ┌──────────────────────────────────────────┐
        │ Select and disconnect iᵗʰ photovoltaic string │ ─── S1
        └──────────────────────────────────────────┘
                               │
     ┌───────────────────────────────────────────────┐
     │ Select and disconnect (i+1)ᵗʰ photovoltaic string │ ─── S2
     └───────────────────────────────────────────────┘
```

Select and disconnect $i^{th}$ photovoltaic string — S1

Select and disconnect $(i+1)^{th}$ photovoltaic string — S2

| S3 | S6 |
|---|---|
| Connect $(i+1)^{th}$ photovoltaic string to first measurement unit | Connect $i^{th}$ photovoltaic string to second measurement unit |
| S4 | S7 |
| Apply direct current voltage | Apply direct current voltage |
| S5 | S8 |
| Measure and store first voltage value | Measure and store second voltage value |

i = i + 1

S9 — Connect $i^{th}$ photovoltaic string to photovoltaic power generation system

S10 — Is measurement of all photovoltaic strings completed?

NO

YES

S11 — Connect $(i+1)^{th}$ photovoltaic string to photovoltaic power generation system

END

## Fig.7

```
                    ┌─────────────┐
                    │   START     │
                    └──────┬──────┘
                           │
             ┌─────────────────────────┐
             │   Calculate insulation  │─── S12
             │     resistance value    │
             └─────────────┬───────────┘
                           │
  No ground              ╱─── S13  Ground
  fault                ╱             fault
             ┌──────╱ Ground fault ╲──────┐
             │      ╲ determined?  ╱      │
             │        ╲          ╱        │
    S14      │          ╲      ╱          │      S15
┌────────────────────────┐        ┌────────────────────────┐
│ Connect photovoltaic   │        │  Maintain disconnected │
│ string of grand fault  │        │  state of photovoltaic │
│ determination target   │        │  string of grand fault │
│ to photovoltaic power  │        │  determination target  │
│ generation system      │        │                        │
└───────────┬────────────┘        └───────────┬────────────┘
            │                                 │
            └──────────────┬──────────────────┘
                           │
                    ┌──────┴──────┐
                    │    END      │
                    └─────────────┘
```

## Fig.8

| | time1 | time2 | time3 | time4 | time5 | time6 | time7 | time8 |
|---|---|---|---|---|---|---|---|---|
| First photovoltaic string | First voltage value measurement | Second voltage value measurement | | | | | | |
| Second photovoltaic string | | First voltage value measurement | Second voltage value measurement | | | | | |
| Third photovoltaic string | | | First voltage value measurement | Second voltage value measurement | | | | |
| Fourth photovoltaic string | | | | First voltage value measurement | Second voltage value measurement | | | |
| Fifth photovoltaic string | | | | | First voltage value measurement | Second voltage value measurement | | |
| Sixth photovoltaic string | | | | | | First voltage value measurement | Second voltage value measurement | |
| Seventh photovoltaic string | | | | | | | First voltage value measurement | Second voltage value measurement |
| Eighth photovoltaic string | Second voltage value measurement | | | | | | | First voltage value measurement |

EP 2 746 789 A1

# Fig.9

# Fig.10

## Fig.11

START

Select and disconnect $i^{th}$ photovoltaic string — S21

Select and disconnect $(i+1)^{th}$ photovoltaic string — S22

Select and disconnect $(i+2)^{th}$ photovoltaic string — S23

Select and disconnect $(i+3)^{th}$ photovoltaic string — S24

S33
Connect $(i+3)^{th}$ photovoltaic string to firs charging/ discharging unit

S28
Connect $(i+2)^{th}$ photovoltaic string to first measurement unit

S31
Connect $(i+1)^{th}$ photovoltaic string to second charging/ discharging unit

S25
Connect $i^{th}$ photovoltaic string to second measurement unit

S29
Apply direct current voltage

S26
Apply direct current voltage

S34
Charge/discharge

S32
Charge/discharge

S30
Measure and store first voltage value

S27
Measure and store second voltage value

i = i + 1

S35
Connect $i^{th}$ photovoltaic string to photovoltaic power generation system

NO ⟵ S36 Is measurement of all photovoltaic strings completed?

YES

S37
Connect $(i+1)^{th}$ to $(i+3)^{th}$ photovoltaic strings to photovoltaic power generation system

END

## Fig.12

| | time1 | time2 | time3 | time4 | time5 | time6 | time7 | time8 |
|---|---|---|---|---|---|---|---|---|
| First photovoltaic string | Second charging/ discharging | Second voltage value measurement | | | | | First charging/ discharging | First voltage value measurement |
| Second photovoltaic string | First voltage value measurement | Second charging/ discharging | Second voltage value measurement | | | | | First charging/ discharging |
| Third photovoltaic string | First charging/ discharging | First voltage value measurement | Second charging/ discharging | Second voltage value measurement | | | | |
| Fourth photovoltaic string | | First charging/ discharging | First voltage value measurement | Second charging/ discharging | Second voltage value measurement | | | |
| Fifth photovoltaic string | | | First charging/ discharging | First voltage value measurement | Second charging/ discharging | Second voltage value measurement | | |
| Sixth photovoltaic string | | | | First charging/ discharging | First voltage value measurement | Second charging/ discharging | Second voltage value measurement | |
| Seventh photovoltaic string | | | | | First charging/ discharging | First voltage value measurement | Second charging/ discharging | Second voltage value measurement |
| Eighth photovoltaic string | Second voltage value measurement | | | | | First charging/ discharging | First voltage value measurement | Second charging/ discharging |

EP 2 746 789 A1

## Fig.13

# Fig.14

# Fig.15

START

Select and disconnect $i^{th}$ photovoltaic string — S1

Select and disconnect $(i+1)^{th}$ photovoltaic string — S2

S18

Connect positive electrode side of $(i+1)^{th}$ photovoltaic string to second measurement unit

S16

Connect negative electrode side of $i^{th}$ photovoltaic string to first measurement unit

S19

Measure and store positive electrode-side voltage drop value

S17

Measure and store negative electrode-side voltage drop value

$i = i + 1$

S9

Connect $i^{th}$ photovoltaic string to photovoltaic power generation system

S10

Is measurement of all photovoltaic strings completed?

NO

YES

S11

Connect $(i+1)^{th}$ photovoltaic string to photovoltaic power generation system

END

# Fig.16

(a)

Potential relative to ground

(b)

Potential relative to ground

# Fig.17

| | time1 | time2 | time3 | time4 | time5 | time6 | time7 | time8 |
|---|---|---|---|---|---|---|---|---|
| First photovoltaic string | Positive -electrode measurement | Negative -electrode measurement | | | | | | |
| Second photovoltaic string | | Positive -electrode measurement | Negative -electrode measurement | | | | | |
| Third photovoltaic string | | | Positive -electrode measurement | Negative -electrode measurement | | | | |
| Fourth photovoltaic string | | | | Positive -electrode measurement | Negative -electrode measurement | | | |
| Fifth photovoltaic string | | | | | Positive -electrode measurement | Negative -electrode measurement | | |
| Sixth photovoltaic string | | | | | | Positive -electrode measurement | Negative -electrode measurement | |
| Seventh photovoltaic string | | | | | | | Positive -electrode measurement | Negative -electrode measurement |
| Eighth photovoltaic string | Negative -electrode measurement | | | | | | | Positive -electrode measurement |

EP 2 746 789 A1

**Fig.18**

# Fig.19

# Fig.20

Fig.21

# *Fig.22*

```
                    ( START )
                        |
  Select and disconnect iᵗʰ photovoltaic string ─ S21
                        |
  Select and disconnect (i+1)ᵗʰ photovoltaic string ─ S22
                        |
  Select and disconnect (i+2)ᵗʰ photovoltaic string ─ S23
                        |
  Select and disconnect (i+3)ᵗʰ photovoltaic string ─ S24
                        |
```

| S47 | S43 | S45 | S41 |
|---|---|---|---|
| Connect positive electrode side of (i+3)ᵗʰ photovoltaic string to second charging /discharging unit | Connect positive electrode side of (i+2)ᵗʰ photovoltaic string to second charging /discharging unit | Connect negative electrode side of (i+1)ᵗʰ photovoltaic string to first charging/ discharging unit | Connect negative electrode side of iᵗʰ photovoltaic string to first charging/ discharging unit |

S48 Charge/discharge

S44 Measure and store positive electrode-side voltage drop value

S46 Charge/discharge

S42 Measure and store negative electrode-side voltage drop value

i = i + 1

**S35** Connect iᵗʰ photovoltaic string to photovoltaic power generation system

**S36** Is measurement of all photovoltaic strings completed? — NO

YES

**S37** Connect (i+1)ᵗʰ to (i+3)ᵗʰ photovoltaic strings to photovoltaic power generation system

( END )

# Fig.23

EP 2 746 789 A1

| | time1 | time2 | time3 | time4 | time5 | time6 | time7 | time8 | time9 | time10 | time11 | time12 | time13 | time14 | time15 | time16 |
|---|---|---|---|---|---|---|---|---|---|---|---|---|---|---|---|---|
| First photovoltaic string | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | Negative-electrode measurement | | | | |
| Second photovoltaic string | | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | Negative-electrode measurement | | | |
| Third photovoltaic string | | | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | Negative-electrode measurement | | |
| Fourth photovoltaic string | | | | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | Negative-electrode measurement | |
| Fifth photovoltaic string | | | | | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | Negative-electrode measurement |
| Sixth photovoltaic string | Negative-electrode measurement | | | | Positive-electrode charging/discharging | Positive-electrode measurement | Negative-electrode charging/discharging | Negative-electrode measurement | | | | | Positive-electrode charging/discharging | Positive-electrode measurement | Negative-electrode charging/discharging | |
| Seventh photovoltaic string | Negative-electrode charging/discharging | Negative-electrode measurement | | | | | Positive-electrode charging/discharging | Positive-electrode measurement | Negative-electrode charging/discharging | Negative-electrode measurement | | | | | Positive-electrode charging/discharging | Positive-electrode measurement |
| Eighth photovoltaic string | Positive-electrode measurement | Negative-electrode charging/discharging | Negative-electrode measurement | | | | | | Positive-electrode charging/discharging | Positive-electrode measurement | Negative-electrode charging/discharging | Negative-electrode measurement | | | | Positive-electrode charging/discharging |

## Fig.24

# Fig.25

# *Fig.26*

(a)

Potential relative
to ground

(b)

Potential relative
to ground

# Fig.27

```
                    ┌─────────┐
                    │  START  │
                    └─────────┘
                         │
   ┌─────────────────────────────────────────────┐
   │ Select and disconnect iᵗʰ photovoltaic string│  ~S1
   └─────────────────────────────────────────────┘
                         │
   ┌───────────────────────────────────────────────┐
   │ Select and disconnect (i+1)ᵗʰ photovoltaic string│  ~S2
   └───────────────────────────────────────────────┘
                         │
   ┌────────────────────────────┬────────────────────────────┐
   │          ~S51              │           ~S54             │
   │ Connect (i+1)ᵗʰ photovoltaic│ Connect iᵗʰ photovoltaic   │
   │ string to first measurement│ string to second           │
   │ unit                       │ measurement unit           │
   │          ~S52              │           ~S55             │
   │ Apply alternating current  │ Apply alternating current  │
   │ voltage                    │ voltage                    │
   │          ~S53              │           ~S56             │
   │ Measure and store first    │ Measure and store second   │
   │ leakage current value and  │ leakage current value and  │
   │ its waveform               │ its waveform               │
   └────────────────────────────┴────────────────────────────┘
```

i = i + 1

Connect iᵗʰ photovoltaic string to photovoltaic power generation system  ~S9

Is measurement of all photovoltaic strings completed?  ~S10  NO

YES

Connect (i+1)ᵗʰ photovoltaic string to photovoltaic power generation system  ~S11

END

## Fig.28

| | time1 | time2 | time3 | time4 | time5 | time6 | time7 | time8 |
|---|---|---|---|---|---|---|---|---|
| First photovoltaic string | First leakage current value measurement | Second leakage current value measurement | | | | | | |
| Second photovoltaic string | | First leakage current value measurement | Second leakage current value measurement | | | | | |
| Third photovoltaic string | | | First leakage current value measurement | Second leakage current value measurement | | | | |
| Fourth photovoltaic string | | | | First leakage current value measurement | Second leakage current value measurement | | | |
| Fifth photovoltaic string | | | | | First leakage current value measurement | Second leakage current value measurement | | |
| Sixth photovoltaic string | | | | | | First leakage current value measurement | Second leakage current value measurement | |
| Seventh photovoltaic string | | | | | | | First leakage current value measurement | Second leakage current value measurement |
| Eighth photovoltaic string | Second leakage current value measurement | | | | | | | First leakage current value measurement |

EP 2 746 789 A1

# Fig.29

(a)

(b)

*Fig.30*

(a)

(b)

**INTERNATIONAL SEARCH REPORT**

| International application No. |
|---|
| PCT/JP2012/069446 |

A. CLASSIFICATION OF SUBJECT MATTER
*G01R31/02*(2006.01)i, *H01L31/04*(2006.01)i, *H01L31/042*(2006.01)i

According to International Patent Classification (IPC) or to both national classification and IPC

B. FIELDS SEARCHED

Minimum documentation searched (classification system followed by classification symbols)
G01R31/02, H01L31/04, H01L31/042

Documentation searched other than minimum documentation to the extent that such documents are included in the fields searched
Jitsuyo Shinan Koho       1922-1996   Jitsuyo Shinan Toroku Koho   1996-2012
Kokai Jitsuyo Shinan Koho  1971-2012   Toroku Jitsuyo Shinan Koho   1994-2012

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-168156 A  (Mitsubishi Heavy Industries, Ltd.), 23 June 2005 (23.06.2005), paragraphs [0015] to [0017]; fig. 1, 2 (Family: none) | 1-11 |
| A | WO 2010/150601 A1  (Nippon Oil Co., Ltd.), 29 December 2010 (29.12.2010), paragraph [0020]; fig. 1 & EP 2447725 A1      & WO 2010/150601 A1 | 1-11 |
| A | JP 2010-060323 A  (Mazda Motor Corp.), 18 March 2010 (18.03.2010), paragraphs [0032], [0034]; fig. 1, 2 (Family: none) | 1-11 |

| ☒ Further documents are listed in the continuation of Box C. | ☐ See patent family annex. |
|---|---|

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 August, 2012 (30.08.12) | 11 September, 2012 (11.09.12) |

| Name and mailing address of the ISA/ Japanese Patent Office | Authorized officer |
|---|---|
| Facsimile No. | Telephone No. |

Form PCT/ISA/210 (second sheet) (July 2009)

**INTERNATIONAL SEARCH REPORT**

| | International application No. |
|---|---|
| | PCT/JP2012/069446 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 07-325121 A (The Tokyo Electric Power Co., Inc.), 12 December 1995 (12.12.1995), paragraphs [0017], [0018] (Family: none) | 1-11 |
| A | JP 11-218554 A (Matsushita Electric Industrial Co., Ltd.), 10 August 1999 (10.08.1999), paragraphs [0051] to [0065]; fig. 14 (Family: none) | 1-11 |

Form PCT/ISA/210 (continuation of second sheet) (July 2009)

**EP 2 746 789 A1**

**Patent documents cited in the description**

- JP 2003158282 A